# EUROPEAN PATENT APPLICATION

(11) **EP 4 793 814 A1**
(43) Date of publication of application: **19.08.2026**
(21) Application number: 25158635.0
(22) Date of filing: 18.02.2025
(51) Int. Cl.: G06F 30/392, G06F 30/394, G06F 30/398, H10D 84/85, H10D 89/10

(54) **A METHOD FOR DESIGNING AN INTEGRATED CIRCUIT**

(71) Applicant: Imec VZW, 3001 Leuven (BE)
(72) Inventor: KÜKNER, Selahaddin Halil, 3053 Haasrode (BE); HELLINGS, Geert, 1500 Halle (BE); LIN, Ji-Yung, 3001 Heverlee (BE); MIRABELLI, Gioele, 3000 Leuven (BE); ZOGRAFOS, Odysseas, 3010 Kessel-Lo (BE)
(74) Representative: Lind Edlund Kenamets Intellectual Property AB

(57) **Abstract**

In an aspect there is provided a computer-implemented method for designing an IC comprising CFET devices. The method comprises obtaining a functional description of the integrated circuit, and generating, based on the functional description, a layout of the integrated circuit. The layout defines first and second cell rows extending in parallel in a horizontal direction of the layout, and having equal row heights in a vertical direction of the layout. Generating the layout comprises placing first and second cells of a standard cell library in the layout. Each cell has a cell height equal to the row height, and comprises first and second cell edges extending in parallel in the horizontal direction. Each cell further comprises at least one CFET device having an active pattern extending in the horizontal direction. Each cell further comprises at least one local interconnect (LI) disposed on the second cell edge and configured to connect to a top and/or bottom S/D of a CFET device of the cell. The first and second cells are placed in the first and second cell rows, respectively, such that: the first cell edge of the first cell aligns with a first row boundary, the first cell edge of the second cell aligns with a second row boundary, and the second cell edges of the first and second cells align with and abut each other along a third row boundary between the first and second cell rows. The placement of the first and second cells is constrained such that the local interconnects of the first and second cells do not overlap.

## Description

### TECHNICAL FIELD

The present invention generally relates to a method for designing an integrated circuit comprising Complementary Field-Effect Transistor (CFET) devices.

### BACKGROUND

The CFET device is a stacked transistor structure comprising a bottom transistor and a top transistor stacked over the bottom transistor. The bottom and top transistors (or bottom and top devices) are of complementary conductivity types (e.g., an NMOS device stacked on top of a PMOS device, or vice versa). The CFET thus allows a reduced footprint compared to a traditional side-by-side arrangement of a complementary transistor pair. The CFET is hence an enabling technology for denser and more area-efficient circuits.

Standard cell methodology enables a circuit designer to efficiently design an integrated circuit (IC) by combining standard cells (SDCs) from a standard cell library. Each standard cell of a standard cell library may comprise a set of active devices (e.g., transistors such as CFETs), and associated metal interconnects and be configured to provide a certain circuit function. A significant portion of the functionality of an IC is provided by logic cells, e.g., implementing various logic gates such as NOT, AND, OR, NOR, etc.

To increase the device density and performance of ICs, considerable effort has been put into advancing design and process technology to reduce the cell height and cell area of standard logic cells, and to optimize usage of routing resources in the interconnect layers above the cell area (e.g., in the "M0" interconnect layer) to mitigate routing congestion and enable standard cell track height reduction. The two device tiers (bottom and top) of the CFET device introduces additional challenges in these efforts.

### SUMMARY

It is an object of the present invention to provide an improvement over existing methods for designing ICs using standard cell methodology, in particular ICs comprising CFET devices. More specifically, it is an object to provide a method for designing an IC comprising CFET devices using standard cells, achieving one or more of improved area efficiency, reduced cell height, and reduced track height. Further and alternative objectives may be understood from the following.

According to a first aspect of the present invention, there is provided a computer-implemented method for designing an integrated circuit (IC) comprising complementary field-effect transistor (CFET) devices. The method comprises obtaining a functional description of the integrated circuit, and generating, based on the functional description, a layout of the integrated circuit. The layout defines first and second cell rows extending in parallel in a horizontal direction of the layout, and having equal row heights in a vertical direction of the layout. The first cell row has a first row boundary, the second cell row has a second row boundary, and the first and second cell rows are separated by a shared third row boundary. Generating the layout comprises placing a first and a second cell of a standard cell library in the layout. Each cell has a cell height equal to the row height, and comprises first and second cell edges extending in parallel in the horizontal direction. Each cell further comprises at least one CFET device having an active pattern extending in the horizontal direction. Each cell further comprises at least one local interconnect disposed on the second cell edge and configured to connect to a top and/or bottom source/drain (S/D) of a CFET device of the at least one CFET device of the cell. The first and second cells are placed in the first and second cell rows, respectively, such that: the first cell edge of the first cell aligns with the first row boundary, the first cell edge of the second cell aligns with the second row boundary, and the second cell edges of the first and second cells align with and abut each other along the third row boundary. Thereby, the at least one local interconnect of the first and second cells align to form a common row of local interconnects on the third row boundary. Further according to the method, the placement of the first and second cells is constrained such that the local interconnects of the first and second cells do not overlap.

The method of the first aspect enables two (first and second) CFET-based standard cells, each spanning half the height of a double-row CFET structure, to be placed side-by-side with abutting cell edges, and hence share a single row of local interconnects between the cells.

In a typical conventional CFET-based standard cell implementation, a power rail structure is provided on both sides of every row of CFET devices. In contrast, in a standard cell implementation based on the double-row CFET structure (which hereinafter may be termed "a full-height DR CFET standard cell"), the space between its two neighboring rows of CFET devices (which hereinafter may be termed "middle outer zone") is utilized to accommodate a row of local interconnects shared by the two rows of CFET devices. Hence, in the full-height DR CFET standard cell, signal routing to/from/between S/Ds of the CFET devices of the two CFET rows may be provided in the middle outer zone. Power routing may meanwhile be provided along the horizontal cell edges on either side of the two CFET rows (which hereinafter may be termed "power routing zones"). Routing congestion between the CFET rows may hence be reduced, which in turn may facilitate realizing DR CFET standard cells with scaled cell height and reduced track height cell height and reduced track height standard cell implementations.

However, some types of standard cells may be implemented utilizing one or more CFET devices of only a single row of the DR CFET structure. Non-limiting examples of such standard cells include standard cells implementing relatively basic / simple logic gates, such as inverter (INV or NOT) gates, buffer (BUFF) gates, NAND gates, NOR gates, AND gates, OR gates, AND-OR (AO) gates, AND-OR-INV (AOI) gates, OR-AND (OA) gates, and OR-AND-INV (OAI) gates. Hence, as realized by the inventors, where a given logic function of a DR CFET standard cell may be implemented using only one of the CFET rows, half of the cell area becomes unutilized. Since such basic standard cells may account for a relatively large proportion of the total number of standard cells of an IC this may, to various degrees, offset the gains in area-efficiency enabled by the double-row CFET structure.

Based on this insight, the method of the first aspect provides a first and second cell of a standard cell library, the cells comprising one or more CFET devices of a single respective row of a DR CFET structure. Thus, the cell heights of the first and second cells may equal half the cell-height of the DR CFET standard cell. Hence, two (first and second) "half-height DR CFET standard cells" may be accommodated within the vertical footprint as a single "full-height DR CFET standard cell". This in turn allows two such half-height DR CFET standard cells to be placed side-by-side, wherein the above-mentioned scenario of unutilized cell area may be mitigated.

By the constraint imposed on the placement of the first and second cells, overlap between the local interconnects of the first and second cells may be avoided, such that the placement may be performed by an automatic place-and-route (PnR).

In accordance with the DR CFET structure, the local interconnects of the first and second cells are comprised / disposed in a bottom and top CFET device tier. This applies correspondingly to the corresponding local interconnects of any other DR CFET standard cells of either half-height or full-height, placed in the layout.

In some embodiments, the first and second cells each further comprise: a bottom and top power rail track associated with a bottom and top CFET device tier, respectively, wherein the bottom and top power rail tracks are disposed on the first cell edge with the top power rail track overlapping the bottom power rail track. Thus, first and second supply voltages may be supplied via the bottom and top power rail tracks, respectively, from the same side of the CFET device(s) of the respective cell, i.e., its power routing zone. The bottom power rail track may be for a pull-up voltage rail and the top power rail track may be for a pull-down voltage rail, or vice versa.

In some embodiments, the bottom power rail track is comprised in a backside interconnect layer of the layout, and the top power rail track is comprised in a top transistor / device tier comprising the top transistors / devices of the at least one CFET device of the respective cell. The power rails need hence not contribute appreciably to routing congestion in frontside interconnect layers of the layout, at a level over the top transistor tier. Rather, bottom and top transistors of a CFET device of the respective cell may be simply coupled with the power rails in the bottom or top power rail tracks by a vertical extension (i.e., transverse to the row directions) of its S/D contact portion in the layout.

In some embodiments, the bottom and top power rail tracks of the first and second cells are vertically centered on the respective first cell edges. Hence, half the width (i.e., height in the vertical dimension) of the power rail tracks may be comprised within the footprint / area of the cell. This allows the footprint of the power rail tracks to be shared equally with a cell comprising a neighboring DR CFET structure.

In some embodiments, the local interconnects of the first and second cells are vertically centered on the respective second cell edges. Thus, the at least one local interconnect of the first and second cells may be vertically centered on the respective second cell edges. The row of local interconnects defined by placing the cells in accordance with the method of the first aspect, may thus be centered on and aligned with the third cell row (i.e., along which the second cell edges abut).

In some embodiments, the standard cell library further comprises cell layout data associated with the first and second cells, the cell layout data indicating coordinates for the local interconnects within the respective cells, wherein the placement of the first and second cells is based on the cell layout data. Thus, based on the coordinates of the respective local interconnects, the placement procedure (e.g., of an automatic PnR) may ensure the cells are placed to avoid placement conflicts between the local interconnects of the first and second cells. In particular, the placement constraints may be adapted to the specific location(s) of the local interconnect(s) of the given cell implementation.

In some embodiments, the placement of the first and second cells is constrained such that the local interconnects are separated by at least a predetermined minimum spacing in the horizontal direction. Hence, the placement constraint may comprise enforcing a minimum-spacing design rule for the local interconnects. Thereby, the first and second cells may be placed so as to ensure that the horizontal minimum spacing of the local interconnects on the third cell row is complied with.

In some embodiments, the first and second cells each comprise a set of signal routing tracks comprising an edge track disposed along the second cell edge of the respective cell, wherein the placement of the first and second cells further is constrained such that any metal lines disposed in the edge tracks of the first and second cells do not overlap.

By this further constraint imposed on the placement of the first and second cells, a placement conflict between any metal line in the edge track of the first cell and any metal line in the edge track of the second cell may be avoided, such that the placement may be performed by an automatic PnR. This may be especially useful in implementations where the edge tracks align along the third row boundary to define a shared signal routing track between the first and second cell rows, shared by the first and second cells. This may for example occur in implementations where the half-height cells have a half-integer track height (discussed below).

The standard cell library may further comprise cell layout data associated with the first and second cells, the cell layout data indicating coordinates for any metal lines of the edge track of the respective cells, wherein the placement of the first and second cells is based on the cell layout data. The placement of the first and second cells may be constrained such that any metal line in the edge track of the first cell is separated from any metal line in the edge track of the second cell by at least a predetermined minimum spacing in the horizontal direction. Hence, the placement constraint may comprise enforcing a minimum-spacing design rule also for any metal lines of the edge tracks.

In some embodiments, the first cell is configured to implement a first logic gate and the second cell is configured to implement a second logic gate. The first and second cells may thus be logic standard cells. In some embodiments, the first and second logic gates are identical logic gates. In some embodiments, the first and second logic gates are different logic gates. The first and second logic gates may for example be any one of: a NOT gate, a BUFF gate, a NAND gate, a NOR gate, an AND gate, an OR gate, an AND-OR gate, an AND-OR-INV gate, an OR-AND gate, an OR-AND-INV gate.

In some embodiments, the first and second cells each have a track height of N. The number N may typically be an integer or a half-integer.

In some embodiments, generating the layout further comprises placing a third cell of the standard cell library in the layout, the third cell having a cell height equal to two times the row height. The third cell comprises first and second cell edges extending in parallel in the horizontal direction. The third cell further comprises at least one first CFET device comprising a first active pattern and at least one second CFET device comprising a second active pattern, the first and second active patterns extending in parallel in the horizontal direction. The third cell further comprises at least one local interconnect disposed mid-way between the first and second cell edges and configured to connect to a top and/or bottom S/D of a CFET device of the at least one first CFET device, and/or of a CFET device of the at least one second CFET device. Thereby, full-height DR standard cells and half-height DR standard cells may be combined in a same layout, combining their respective benefits outlined above.

In some embodiments, the third cell is placed in the first and second cell rows such that its first cell edge aligns with the first row boundary, its second cell edge aligns with the second row boundary, and its at least one local interconnect aligns with the third row boundary, wherein the local interconnects of the first, second and third cells align to form a common row of local interconnects on the third row boundary. Full- and half-height DR standard cells may hence be combined in a same pair of (half-height) cell rows. This further contributes to the flexibility and area-efficiency of the generated layout.

In some embodiments, where the third cell is placed in the first and second cell rows, the first active pattern of the third cell aligns with the active pattern of the first cell and second active pattern of the third cell aligns with the active pattern of the second cell. Hence, the at least one first CFET device of the third cell and the at least one CFET device of the first cell may form a first row of CFET devices extending in the horizontal direction between the first and third row boundaries. Correspondingly, the at least one second CFET device of the third cell and the at least one CFET device of the second cell may form a second row of CFET devices extending in the horizontal direction between the second and third row boundaries.

In some embodiments, the layout further defines third and fourth cell rows parallel to the first and second cell rows and having equal row heights to the first and second cell rows. The third cell row has a fourth row boundary. The fourth cell row has a fifth row boundary. The third and fourth cell rows are separated by a shared sixth row boundary. The third cell is placed in the third and fourth cell rows such that its first cell edge aligns with the fourth row boundary, its second cell edge aligns with the fifth row boundary, and its at least one local interconnect aligns with the sixth row boundary. The third full-height DR standard cell may hence be arranged in a different pair of (half-height) cell rows.

In some embodiments, the third cell further comprises first bottom and top power rail tracks associated with a bottom and top CFET device tier, respectively, of the at least one first CFET device, and disposed on the first cell edge with the first top power rail track overlapping the first bottom power rail track. The third cell further comprises second bottom and top power rail tracks associated with a bottom and top device tier, respectively, of the at least one second CFET device, and disposed on the second cell edge with the second top power rail track overlapping the second bottom power rail track. The third cell may thus, in accordance with the DR CFET structure, be powered via two pairs of stacked power rail tracks disposed in the power routing zones at the first and second cell edges. More specifically, the at least one first CFET device may be powered via the first bottom and top power rail tracks, and the at least one second CFET device may be powered via the second bottom and top power rail tracks.

In some embodiments, the third cell has a track height of 2 times N (where N is the track height of the half-height cells).

In some embodiments, the third cell is configured to implement a third logic gate. The third cell may thus be a logic standard cell. In embodiments where the first and second logic gates implement first and second logic gates, respectively, the third logic gate may be different from the first and second logic gates. The third logic gate may for example implement a more complex logic gate, involving a combination of multiple basic gates.

According to a second aspect, there is provided a method of fabricating an IC comprising: designing the integrated circuit according to the method of the first aspect or any embodiments thereof, thereby obtaining a layout of the IC. The method further comprises fabricating the integrated circuit in accordance with the layout. Thus, the design method of the first aspect may form part of, or in other words be extended to, a method for fabricating the IC. The benefits discussed in connection with the first aspect may thus be conveyed to a physical realization of the layout.

According to a third aspect, there is provided a system for designing an IC comprising CFETs, the system comprising: a processing device, and a computer-readable storage medium storing instructions configured to, when executed by the processing device, cause the processing device to perform the method of the first aspect or any embodiments thereof.

According to a fourth aspect, there is provided a computer program product comprising instructions configured to, when executed by a processing device, cause the processing device to perform the method of the first aspect or any embodiments thereof.

In general, any embodiment, feature, effect or advantage discussed in connection with the first aspect applies correspondingly to the second, third and fourth aspects.

### BRIEF DESCRIPTION OF THE DRAWINGS

The above, as well as additional objects, embodiments, features and effects of the present invention, may be better understood through the following illustrative and non-limiting detailed description, with reference to the appended drawings. In the drawings like reference numerals will be used for like elements unless stated otherwise.
Fig. 1 schematically shows an example of a double-row (DR) CFET structure comprised in a full-height DR CFET standard cell.
Fig. 2 schematically shows a further example of a DR CFET structure comprised in a full-height DR CFET standard cell.
Fig. 3 schematically shows a further example of a DR CFET structure comprised in two half-height DR CFET standard cells.
Fig. 4 schematically shows, as a comparative example, a logic cell comprising a double-row CFET implementing a single inverter gate.
Fig. 5 schematically show two abutting half-height DR CFET standard cells (left) and a full-height DR CFET standard cell (right).
Fig. 6a-b show, respectively, a top-down view of a layout of an IC comprising a combination of half- and full-height DR CFET standard cells, and an enlargement of a region of the layout.
Fig. 7 is a flowchart of a method for designing an IC comprising CFET devices, such as the IC of Fig. 6a-b.
Fig. 8a-b schematically depict how an automatic placement and routing tool can resolve conflicts during placement of abutting half-height DR CFET standard cells.
Fig. 9a-b show example circuit layouts of top and bottom transistor tiers of a half-height DR CFET standard cell implementing an inverter gate.
Fig. 10a-c show example circuit layouts of a top transistor tier, a bottom transistor tier, and a backside interconnect layer, respectively, of a half-height DR CFET standard cell implementing a NAND gate.
Fig. 11 shows a further example layout comprising three abutting half-height DR CFET standard cells.
Fig. 12 shows a schematic block diagram of a system in which the method of Fig. 7 may be implemented.

### DETAILED DESCRIPTION

In the following, a detailed description of the so-called double-row (DR) CFET structure or architecture, as well as IC devices, IC layouts, standard cells, standard cell libraries and IC layout methods based on the DR CFET structure, will be provided with reference to the drawings. For conciseness, the term "standard cell" may in the following be abbreviated by the term "cell". The drawings are only schematic and the relative dimensions of illustrated elements, such as layers or other structures, may be exaggerated and not drawn to scale. Rather the dimensions may be adapted for illustrational clarity and to facilitate understanding. As is customary in layouts and floorplans of ICs, the terms "horizontal" and "vertical" are in the present disclosure used to refer to two mutually transverse directions (e.g., "first" and "second" directions) parallel to the main plane of extension or footprint of the layout. Consistent with this definition, when present in the figures, the axes X and Y points in the horizontal direction (from left to right in the figures) and the vertical direction (bottom-up in the figures), respectively. Thus, as will become apparent from the figures and the associated description, the X direction corresponds to each of a row direction of the cell rows, a width dimension (cell width) of the cells, and a direction of extension of the CFET rows and local interconnect rows. Correspondingly, the Y direction corresponds to a height dimension (cell height) of the logic cells. In some instances, the Y direction may also be referred to as a lateral direction with respect to the horizontal direction of the CFET rows. The Z direction points in a normal direction to the main plane of extension of the layout, or equivalently, normal to a substrate plane of the IC. The Z direction thus corresponds to a direction of increasing elevation or level of the layout. Accordingly, terms indicating relative elevational arrangement of elements, such as "top", "upper", "bottom", "lower" and the like, are to be understood in relation to the Z direction.

It is to be noted that when an element (e.g. an interconnect, a contact, a layer or other structure) herein is referred to as being "on" another element, it can be directly on the other element or on one or more intermediate elements on the other element. Conversely, when an element is referred to as being "directly on" another element, there is no intermediate element and the element is thus abutting (i.e., physically contacting) the other element. It is further to be noted that terms such as "first" and "second" etc. with reference to elements (e.g. layers, cells, or other structures or features) may be used herein as labels to facilitate distinguishing between different elements, and need not necessarily imply that such elements are arranged or performed in that particular order, unless stated otherwise. Furthermore, by the term "CFET device" (or shorter, "CFET") is herein meant a device, more specifically a stacked transistor device, comprising a bottom transistor (bottom device) of a first conductivity type and a top transistor (top device) of a second conductive type opposite the first conductivity type stacked on top of / over the bottom transistor, e.g. an NMOS top device stacked on top of a PMOS bottom device, or vice versa. More specifically, the top device is arranged substantially within the footprint of the bottom device. The bottom transistor is comprised in a bottom transistor tier of the IC / layout / cell and the top device is comprised in a top transistor tier of the IC / layout / cell. The bottom and top transistor tiers are each comprised in an active device layer of the IC / layout / cell.

By the term "frontside interconnect structure" is herein meant an interconnect structure (e.g., a back-end-of-line interconnect structure) comprising a stack of interconnect layers (e.g., M0, M1, M2, etc.) arranged on a frontside of an IC or substrate, over the top transistor tier of the CFETs, each at a respective level in the Z direction. When reference herein is made to a "bottom frontside interconnect layer", it is meant the frontside interconnect layer of the frontside interconnect structure closest to the CFETs (i.e., closest to the active device layer and substrate, if present). The bottom frontside interconnect layer may in the following be denoted "the M0 layer". The M0 layer may typically be a minimum metal pitch layer of the frontside interconnect structure, i.e., the interconnect layer of the frontside interconnect structure having the smallest metal line/track pitch.

By the term "backside interconnect structure" is herein meant an interconnect structure comprising one or more interconnect layers (e.g., BM0, BM1, BM2, etc.) arranged (e.g., stacked) on a backside of an IC or substrate, below the CFETs, each at a respective level in the Z direction. When reference herein is made to a "bottom backside interconnect layer", it is meant the backside interconnect layer of the backside interconnect structure closest to the CFETs (i.e., closest to the active device layer and substrate, if present). The bottom backside interconnect layer may in the following be denoted "the BM0 layer".

By the term "interconnect layer" (frontside or backside) is herein meant a layer of horizontally (X) and/or vertically (Y) routed interconnects, e.g., conductive traces, lines and/or line segments. An interconnect layer may also be referred to as a metal line layer, a metal routing layer or a metallization layer. Successive interconnect layers may be interconnected by intermediate via layers (e.g., V0, V1, etc.) comprising vias extending therebetween in the Z direction. The interconnect and via layers may be embedded in interlayer dielectrics. The interconnects (e.g., lines, line segments, contacts) of a given interconnect layer may be arranged in (or along) any one of a set of routing tracks in the given interconnect layer. In the present disclosure, the routing tracks of each layer referred to are assumed to be unidirectional, extending in parallel in either the X direction or the Y direction, and being arranged with a substantially uniform pitch, or at least a regular pitch. As per se is known to the skilled person, an interconnect such as a line or line segment arranged in any given routing track need not extend along the full length of the track, but need only be disposed to define an overlap with respect to the structures that are to be interconnected, such as a contact, a local interconnect or a gate of a transistor or a cell. Further, some routing tracks may even be unused, depending on the routing requirements of the specific logic cell implementation.

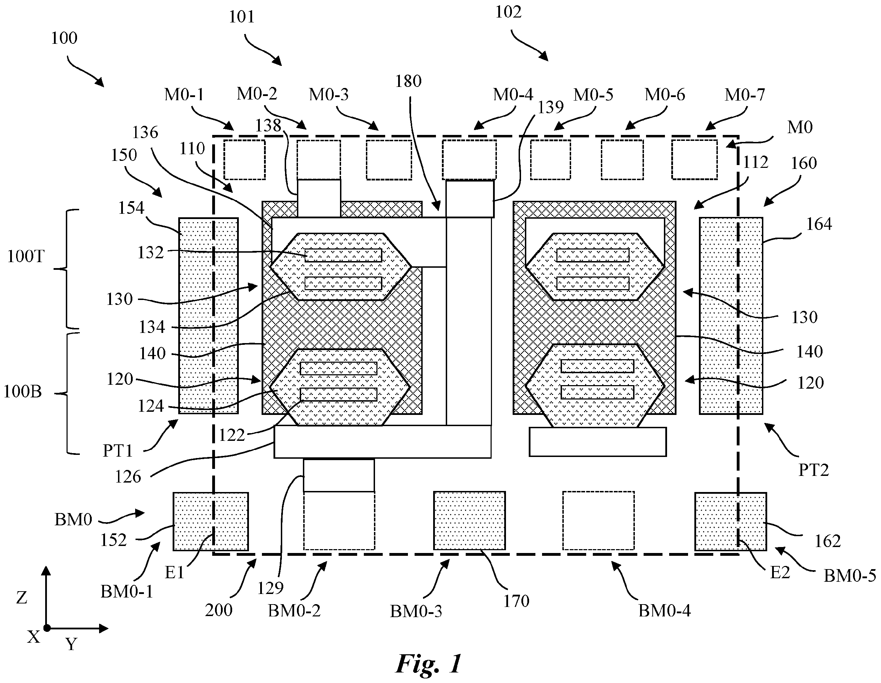

When reference herein is made to one or more (routing) tracks "of' or "associated with" a given standard cell, this is to be understood to mean one or more tracks disposed between its horizontal cell edges (e.g., c.f. edges E1 and E2 in Fig. 1), and thus being comprised in or overlapping the footprint of the cell (where the term "footprint" refers to a footprint in the XY-plane). A track of a cell is typically a track of the M0 layer or BM0 layer. A cell may comprise one or more pins (e.g., signal input pins, signal output pins, power supply pins) along (within the footprint of) any one of its associated tracks.

The layouts and standard cells to be disclosed in the following are based on the DR CFET structure. Example implementations of the DR CFET structure will now be discussed with reference to Fig. 1-2.

Fig. 1 schematically shows two corresponding first and second CFET (devices) 110, 112 of a DR CFET structure 100 of a semiconductor device, such as an IC. The CFETs 110, 112 are comprised in respective CFET rows 101, 102 extending in parallel in the horizontal X direction, e.g., along a substrate of the IC (not individually shown).

While Fig. 1 only shows a single CFET 110, 112 of each CFET row 101, 102, it is noted that each CFET row 101, 102 comprises a plurality of CFETs arranged one after another. It is further noted that the view of Fig. 1 is a partial cross section-partial projection, to allow a simultaneous view of respective S/Ds (i.e., S/D regions, bodies or features) and channel regions of the CFETs 110, 112. Reference will in the following mainly be made to the CFET 110, however as may be seen in Fig. 1, the discussion applies correspondingly to the second CFET 112.

Each CFET 110, 112 comprises a bottom transistor 120 and a top transistor 130 stacked on top of the bottom transistor 120 in the Z direction. The bottom transistor 120 is comprised in a bottom transistor tier 100B and the top transistor 130 is comprised in a top transistor tier 100T. The bottom transistor 120 comprises a bottom S/D 124 (e.g., an epitaxial S/D body) and a bottom channel structure 122 (e.g., one or more stacked nanosheets, typically Si or SiGe-based) extending in the X direction between the bottom S/D 124 and a further bottom S/D at an opposite side of the bottom channel structure 122, located behind the plane shown in Fig. 1. The top transistor 130 comprises corresponding features; a top S/D 134 and a top channel structure 132 (e.g., one or more stacked nanosheets) extending in the X direction between the top S/D 134 and an opposite top S/D.

The CFET 110 further comprises a gate 140 shared by the bottom and top transistors 120, 130. The gate 140 is arranged to surround the bottom and top channel structures 122, 132 along the channel region of the CFET 110, e.g., completely in a gate-all-around (GAA) fashion. As exemplified by the gates 140 of the CFETs 110, 112 of the CFET rows 101, 102, in accordance with the DR CFET architecture, the gates of two aligned (side-by-side) CFETs of the first and second CFET rows are arranged along a common "gate track". Each such gate track is a vertical track and thus extends in the Y direction. The contacted poly pitch (CPP) of the CFETs of the CFET rows 101, 102 define the minimum spacing / pitch of consecutive gate tracks.

The CFET 110 further comprises a S/D contact structure comprising a bottom S/D contact or contact portion 126 electrically connected to (by abutting) the bottom S/D 124, and a top S/D contact or contact portion 136 electrically connected to (by abutting) the top S/D 134. The top S/D contact 136 is separated from the bottom S/D contact portion 126 in the Z direction. The bottom and top S/D contacts 126, 136, and the bottom and top S/Ds 124, 134 may be separated by, for instance, an intermediate insulating layer portion (e.g., an inter-layer dielectric such as silicon oxide).

In Fig. 1, the bottom S/D contact 126 is schematically shown as a layer-like feature abutting the bottom S/D 124 from below. However, this is just an example and the bottom S/D contact 126 may also be formed to wrap around the bottom S/D 124, fully or partly. This applies correspondingly to the top S/D contact 136. The bottom S/D contact 126 may also be referred to as bottom metal diffusion (which herein may be denoted "BMD") while the top S/D contact 136 may be referred to as top metal diffusion (which herein may be denoted "MD"). The bottom S/D contact 126 may beneficially be formed during backside processing, subsequent to the frontside processing (discussed below). The bottom and top S/D contacts 126, 136 may as set forth in the below be electrically accessed, (e.g., interconnected) by a local interconnect LI 180.

The two CFET rows 101, 102 are in accordance with the DR CFET architecture surrounded by a pair of first and second power rail structures 150, 160 extending along laterally opposite sides of the CFET rows 101, 102. Thus, the CFET rows 101, 102 are arranged between and extend in parallel to the first and second power rail structures 150, 160.

Each power rail structure 150, 160 comprises a bottom power rail 152, 162 and a top power rail 154, 164 stacked over the respective bottom power rail 152, 162, at a level (i.e., an elevational level along the Z-direction) above the bottom power rails 152, 162. Each top power rail 154, 164 is thus arranged at least substantially within the footprint of its associated bottom power rail 152, 162. The bottom power rails 152, 162 may be configured as pull-up voltage rails (VDD) and the top power rails 154, 164 may be configured as pull-down voltage rails (VSS), or vice versa, such that each power rail structure 150, 160 may supply both a pull-up and pull-down voltage to the CFETs of their respective neighboring CFET row 101, 102. Thereby, each CFET 110, 112 may be supplied power from a single side, i.e., a respective power routing zone disposed outside of the CFET rows 101, 102. In general, where the CFETs 110, 112 are of a NMOS-on-PMOS configuration, the bottom power rails 152, 162 may be VDD rails and the top power rails 154, 164 may be VSS rails. In case of a PMOS-on-NMOS configuration, the roles of the bottom and top power rails 152, 162 and 154, 164 may be reversed.

Further in accordance with the DR CFET architecture, the space ("the middle outer zone") between the first and second CFET rows 101, 102 accommodates a row of local interconnects (LIs) 180, one such LI 180 being visible in Fig. 1. The row of LIs 180 is arranged between and extends in parallel to the first and second CFET rows 101, 102. The first CFET row 101 is arranged between the first power rail structure 150 and the row of LIs 180. The second CFET row 102 is arranged between the second power rail structure 160 and the row of LIs 180. The row of LIs 180 may be substantially centered between the CFET rows 101, 102 and between the power rail structures 150, 160. The row of LIs 180 may extend between the CFET rows 101, 102, along the full length thereof, or along parts (segments) thereof.

The LIs 180 may be substantially pillar or wall-shaped metal interconnects. The shown LI (and any number of further LIs of the row of LIs 180) may as shown be arranged in, i.e., extend between the bottom and top transistor tiers 100B, 100T. The LIs 180 may thus have an extension in the Z direction matching a combined extension of the bottom and top transistor tiers 100B, 100T. Each LI 180 may, in particular, extend in the Z direction between a bottom portion (bottom end portion) located in the bottom transistor tier 100B and a top portion (top end portion) located in the top transistor tier 100T. This stands in contrast to the conventionally used "tall vias", which during fabrication are formed to extend continuously from the M0 interconnect layer to the bottom tier 100B, or continuously from the top tier 100T to the backside interconnect layer BM0. Hence, tall vias have a greater height and aspect ratio than the LIs 180, and therefore introduce additional complexity during fabrication.

The row of LIs 180 may comprise a respective LI between any pair of aligned S/Ds of the CFET rows 101, 102. The row of LIs 180 may comprise a respective LI between any pair of consecutive gate tracks. A minimum pitch of the LIs 180 may thus correspond to the CPP of the CFETs.

Any LI of the row of LIs 180 may be coupled to one or more bottom and/or top transistors of the first or second row of CFETs 101, 102. In Fig. 1, this is shown by way of example for the first CFET 110, wherein the depicted LI 180 is configured to interconnect the bottom and top S/D contacts 126, 136. The bottom and top S/D contacts 126, 136, and the LI 180 are thus comprised in, i.e., form part of, a common or shared S/D contact structure of the CFET 110. The bottom and top S/D contacts 126, 136 may as shown extend laterally in the Y direction, between the bottom and top S/Ds 124, 134, respectively, and the LI 180 to electrically connect the bottom and top S/Ds 124, 134 to the LI 180.

The bottom S/D contact 126 is in the illustrated example shown to extend laterally in the Y direction into a footprint of the row of LIs 180. The bottom S/D contact 126 thus undercuts the row of LIs 180 such that the LI 180 may contact or land on the bottom S/D contact 126 from above. The lateral extension of the bottom S/D contact portion 126 may analogously be related to the backside or frontside center tracks BM0-3 or M0-4 (discussed below). That is, the bottom S/D contact 126 may extend in the Y direction into (i.e., overlap or intercept) the backside or frontside center tracks BM0-3 or M0-4. It is however to be noted that the specific configuration of the bottom S/D contact 126 may vary depending on details of the device fabrication process. For instance, a connection between the LI 180 and the bottom S/D contact 126 may also be realized by forming the LI 180 to protrude into the level of the bottom S/D contact 126 such that the bottom S/D contact 126 instead may contact the LI 180 from the side (i.e., abut a sidewall of the LI 180). Further, while in Fig. 1, the bottom S/D contact portion 126 is schematically shown as a single integrally formed contact body contacting the bottom S/D 124, the bottom S/D contact portion 126 may comprise a first sub-portion abutting the bottom S/D 124 from below, and a second sub-portion abutting the first sub-portion from below. The lateral connection to the LI 180 may thus be realized by arranging the second sub-portion to extend between the first sub-portion and the LI 180. Where the bottom S/D contact portion 126 is formed during backside processing, the second sub-portion may typically be formed after forming the first sub-portion.

The top S/D contact 136 is in the illustrated example shown to extend laterally to contact the LI 180 from the side, thus abutting a sidewall of the LI 180. However, analogous to the above discussion of the bottom S/D contact 126, other configurations are also possible. For instance, in case of a shorter LI 180 (i.e., less tall in the Z direction) the top S/D contact 136 may be further extended in the Y direction, into the footprint of the row LIs 180 and contact the LI 180 from above.

While in the illustrated example, the LI 180 is configured to interconnect the top and bottom S/D contacts 126, 136, it is also possible to use the LI 180 to access only one of the bottom and S/Ds of the CFET 110. That is, only one of the bottom and top S/D contacts 126, 136 may be configured to contact the LI 180.

The DR CFET structure 100 as shown in Fig. 1 may beneficially be used to realize a standard cell spanning the width (in the Y direction) of the DR CFET structure 100 such that both of the first and second CFET rows 101, 102 extend through the footprint of the standard cell. This type of standard cell is in the present disclosure termed "a full-height DR CFET standard cell" (abbreviated "full-height cell").

Fig. 1 indicates with dashed lines respective locations of a pair of opposite cell boundaries or cell edges E1, E2 of such a full-height cell 200. The cell edges E1, E2 extend in parallel in the horizontal X direction and are spaced apart in the vertical Y direction. The cell height of the full-height cell 200 is the distance between the cell edges E1, E2. The cell height may also be defined in terms of the number of signal routing tracks associated with the cell 200, and thus disposed between its horizontal cell edges E1, E2. This is also referred to as "the track height" of the cell 200. The track height is typically defined in terms of the number of tracks of the bottom frontside interconnect layer M0.

Thus, as shown in Fig. 1, the DR CFET structure can be used to implement a full-height cell 200 as a 7-track height (7T) cell, thus comprising 7 frontside routing tracks, M0-1 to M0-7, of the M0 frontside interconnect layer. More specifically, the M0 layer comprises a first track M0-1 disposed as an outer track (edge track) adjacent the first cell edge E1, and a seventh track M0-7 disposed as an outer track (edge track) adjacent the second cell edge E2. The M0-1 and M0-7 tracks may as shown be separated from, i.e., offset relative to, the respective cell edges E1, E2 in the Y direction by a distance. This allows a corresponding M0 track of a neighboring cell (e.g., a corresponding M0-1 or M0-7 track) to be disposed on the opposite side of the respective cell edge E1 and E2, with a margin to the M0-1 or M0-7 track of the cell 200. The distance may for example be equal to half a minimum track / line spacing of the M0 layer. The M0 layer further comprises a fourth track M0-4 disposed as a center track aligned with the centerline of the cell 200. The center track M0-4 is further aligned with the row of LIs 180 (e.g., the horizontally extending centerline of the row of LIs 180). The M0 layer further comprises two pairs of off-center tracks M0-2, M0-3 and M0-5, M0-6, between the edge and center tracks M0-1, M0-4 and M0-4, M0-7, respectively.

In the depicted example, the non-center tracks M0-1, M0-2, M0-3, M0-5, M0-6 and M0-7 of the cell 200 have a substantially uniform width (i.e., in the Y direction) while the center track M0-4 is formed with a greater width than the non-center tracks. However, it is also possible to realize the cell 200 wherein all seven tracks M0-1 to M0-7 have a uniform width. In general, in a cell implementation with an odd number of M0 tracks and a given target standard cell height (e.g., as set by the technology node), a wider center track may be used if the cell height is not evenly divisible by the number of M0 tracks. If this is not the case, a slightly wider center track may be used to obtain a regular track distribution with a height matching the given cell height.

The cell 200 may (e.g., in the 7 track full-height implementation) as shown further be associated with a number of backside routing tracks of a bottom backside interconnect layer BM0 of a backside interconnect structure. More specifically, the BM0 layer comprises here as shown five backside routing tracks, denoted BM0-1 to BM0-5. The backside tracks BM0-1 to BM0-5 may have a uniform width and spacing. The BM0 layer comprises first and fifth (backside) tracks BM0-1 and BM0-5 aligned with (disposed on) the cell edges E1 and E2, respectively. The BM0-1 and BM0-5 tracks thus define a pair of backside outer tracks (edge tracks) of the cell 200. The cell edges E1, E2 may more specifically align with the respective centerlines of the BM0-1 and BM0-5 tracks. This enables sharing of the backside edge tracks BM0-1 and BM0-5 across the cell edges of abutting cells. The BM0 layer further comprises a third backside track BM0-3 disposed as a center track aligned with the centerline of the cell 200. The center track BM0-3 is further aligned with the row of LIs 180 (e.g., the horizontally extending centerline of the row of LIs 180). The BM0 layer further comprises first and second off-center tracks BM0-2 and BM0-4, between the edge and center tracks BM0-1, BM0-3 and BM0-5, BM0-3, respectively.

In the depicted implementation of the cell 200, the backside edge tracks BM0-1 and BM0-5 are configured as bottom power rail tracks for the first and second CFET row 101, 102, respectively, comprising the bottom power rails 152 and 162, respectively, of the stacked power rail structures 150, 160. The top power rails 154, 164 are arranged in the top transistor tier 100T (i.e., below the M0 layer). Put differently, the top power rails 154, 164 may be arranged in respective top power rail tracks PT1, PT2 disposed or comprised in the top transistor tier 100T.

The edge tracks BM0-1 and BM0-5 may define first global power rail tracks of the IC / layout and the center track BM0-3 may define a second global power rail track of the IC / layout. The first global power rail tracks BM0-1 and BM0-5 and the second global rail track BM0-3 may be first and second types of global power rail track, respectively, of a backside power distribution network of the IC / layout. The first global power rail tracks BM0-1, BM0-5 (the first type) may be global VDD tracks and the second global power rail track BM0-3 (the second type) may be a global VSS track, or vice versa. The bottom power rails 152 and 162 may be configured as first (first types of) global power rails arranged in the first global power rail tracks BM0-1 and BM0-5, respectively. The top power rails 154, 164 / top power rail tracks PT1, PT2 may be configured as local power rails / power rail tracks connected to a second (second type of) global power rail 170 arranged in the second global power rail track BM0-3.

While not expressly shown in Fig. 1, the connection may be provided in a region of the IC / layout outside the cell 200, such as in a region where the connection may be provided without competing for routing resources with connections between bottom and top transistors of the CFET rows 101, 102. For instance, the connection between the local top power rails 154, 164 and the second global power rail 170 may be realized by one or more dedicated power routing cells, each comprising a power routing interconnect structure comprising a "power routing LI" ("power tap LI") of the row of LIs 180. The power routing LI may be connected to the global power rail 170 by a backside contact or via aligned with the center track BM0-3, and further connected to the local top power rails 154, 164 via TMD contacts and/or vias and metal lines of one or more frontside via layers and frontside interconnect layers (e.g., M0 and M1).

In a variation of the illustrated implementation of the stacked power rail structures 150, 160, the bottom power rails 152, 162 may, analogous to the top power rails 154, 164, be arranged in the bottom transistor tier 100B, e.g., in a bottom power rail track disposed or comprised in the bottom transistor tier 100B. In this case, the top power rails 154, 164 may be formed with a smaller dimension in the Z direction, e.g., so as not to extend into the bottom transistor tier 100B or bottom power rail track. The bottom power rails 152, 162 may in this case define local bottom power rails and be connected by a backside contact or via to global power rails in global rail tracks BM0-1 and BM0-5, for example. Further, connections between the bottom S/D 124 of the CFET 110 and the bottom power rail 152 may be realized by laterally extending the BMD / bottom S/D contact 126 towards the cell edge E1. A connection between the bottom S/D of the CFET 112 and the bottom power rail 162 may be realized in a corresponding manner.

Fig. 1 further illustrates how the bottom S/D contact 126 of the first CFET 110 may be connected to a signal routing resource in the backside off-center track BM0-2 by a backside contact or via 129. As further shown in Fig. 1, the top S/D contact 136 of the first CFET 110 may additionally or alternatively be coupled to a metal line in an overlapping M0 track (e.g., the M0-2 track shown in Fig. 1, or the M0-3 track) by a via 138. Fig. 1 further illustrates that the LI 180 may be coupled to a metal line in an overlapping M0 track (i.e., the M0-4 track shown in Fig. 1).

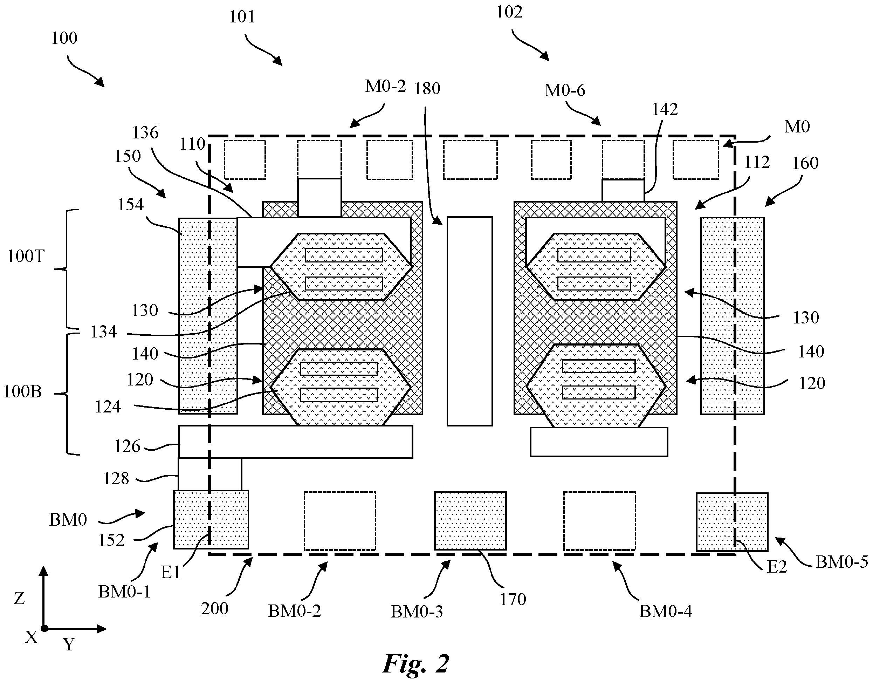

Fig. 2 illustrates a further example implementation of the DR CFET architecture and a full-height DR / 7T cell 200. Fig. 2 is similar to Fig. 1, but further shows how a connection between the bottom S/D 124 of the first CFET 110 and the bottom power rail 152 may be realized by arranging the bottom S/D contact 126 to extend laterally to overlap the bottom edge track BM0-1 and the cell edge E1, and contacting / tapping the bottom power rail 152 by a backside contact or via 128.

Fig. 2 further illustrates that the top S/D 134 may be connected / tapped to the top power rail 154 by arranging the top S/D contact 136 to laterally extend towards the cell edge E1 to contact / abut the top power rail 154. As further shown, the gate 140 of the CFET 112 may be coupled to a metal line in an overlapping M0 track (i.e., the M0-6 track shown in Fig. 1, or the M0-5 track) by a gate via 142.

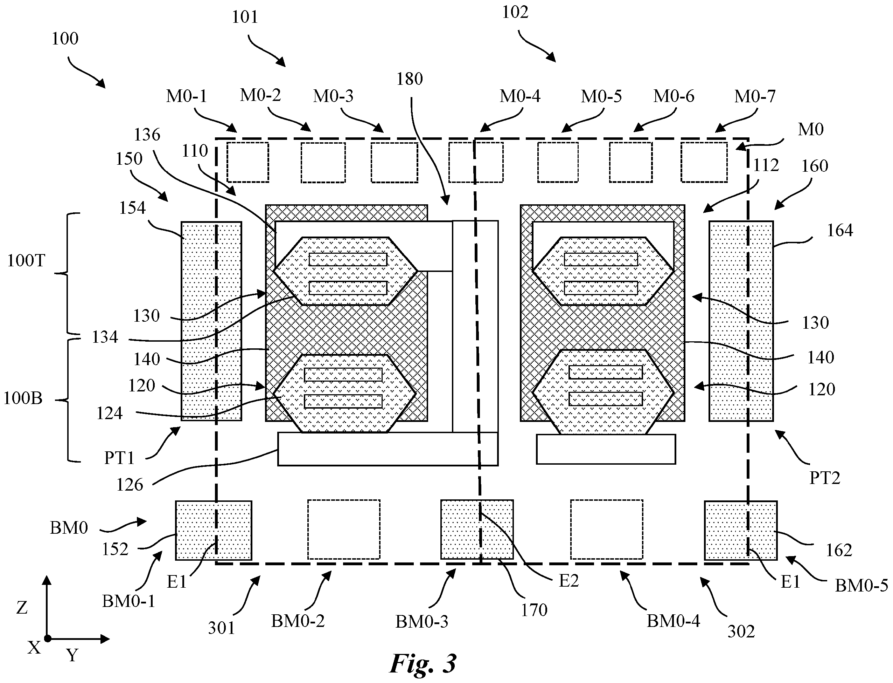

Fig. 3 illustrates a further example implementation of the DR CFET architecture. The depicted implementation is similar to the implementations of Fig. 1 and 2 in that the DR CFET architecture here is used to implement two cells 301, 302 side-by-side, one along each CFET row 101, 102. The first half-height DR cell 301 comprises a first CFET 110 of the first CFET row 101 and the second half-height DR cell 302 comprises a second CFET 112 of the second CFET row 102. The first and second cells 301, 302 each have first and second cell edges E1 and E2, respectively, extending in parallel in the X direction. The second cell edges E2 of the cells 301, 302 are here mutually abutting and hence indicated by the same reference sign. The height of each of the first and second cells 301, 302 are defined by the distance between their respective first and second cell edges E1 and E2. The heights of the cells 301, 302 are each equal to half the height of the cell 200 of Fig. 1-2. Hence, the cells 301, 302 are in the present disclosure termed "half-height DR CFET cells" (abbreviated "half-height cells").

To facilitate comparison to the full-height cells 200, Fig. 3 uses a same labelling of the various tracks (e.g. the M0 and the BM0 tracks) as Fig. 1-2. Thus, as may be seen, the M0 tracks and the BM0 tracks are disposed in a same manner relative the DR CFET structure 100 as in Fig. 1. Accordingly, the first and second cells 301, 302 each have a track height of 3.5T (i.e., 3.5 tracks of the M0 layer). The half-track 0.5T is due to the centerline of the track M0-4 being aligned with the shared cell edge E2 of the first and second cells 301, 302. Thus, the footprint of the M0-4 track (the center track in the cell 200 of Fig. 1) is evenly distributed between the abutting cells 301, 302. Further, first bottom and top power rail tracks BM0-1 and PT1 are disposed on the first cell edge E1 of the first cell 301, and second bottom and top power rail tracks BM0-5 and PT2 are disposed on the first cell edge E1 of the second cell 302. The centerline of the third backside track BM0-3 is like the fourth track M0-4 aligned with the shared cell edge E2.

While the illustrated examples of Fig. 1-3 show half- and full-height cells in specifically 3.5T and 7T implementations, it is noted that the DR CFET structure also may be used to implement half- and full-height cells with other track heights, and that the layout design approaches of the present disclosure also are applicable to such implementations. More generally, the DR CFET structure may be used to implement half-height cells of half-integer or integer track height N, and full-height cells of track height 2*N. A non-limiting example of a half-height cell with an integer track height N is a 4T half-height cells, which gives a track height of 8T for the full-height cells.

A characteristic of the DR CFET structure is that it constrains the full-height DR standard cells to be always in an even cell row layout. As discussed in the above, this may introduce layout inefficiencies and area overhead in some cells, in particular cells which may be implemented using only a single row of the DR CFET structure, such as cells INV cells, NAND cells, NOR cells, AND cells and OR cells.

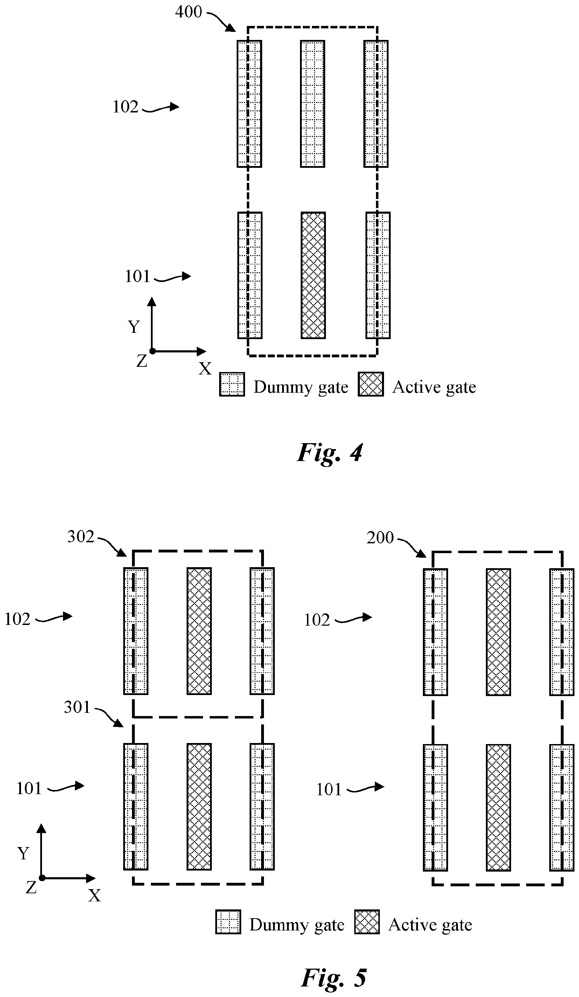

This is schematically illustrated in Fig. 4, wherein only the first CFET row 101 and thus half the footprint (cell area) of the full-height cell 400 (e.g., a 7 T cell) is utilized to implement its logic gate, such as a single-bit INV gate. The second CFET row 102 and the other half of the cell 400 is thus unutilized. It is estimated that for basic cells (such as those mentioned above), this may result in a cell area overhead of 33%, 50% and even 100% in case of an inverter INVD1 cell (i.e., an inverter cell with drive strength D=1). This may translate to around 5% overall logic core area penalty at the block-level.

By supplementing a standard cell library of full-height DR CFET standard cells (e.g., of a 7T height) with half-height DR CFET standard cells (e.g., of a 3.5T height), the manufacturing and area-related benefits of the full-height cells may be provided, while the amount of unutilized cell area may be reduced. This is schematically illustrated in Fig. 5, showing two abutting half-height DR CFET standard cells 301, 302 (left) and a full-height DR CFET standard cell 200 (right).

In some embodiments of a half-height cell, such as cells 301, 302, a logic gate / logic function of the cell may be implemented by N ≥ 1 CFETs of one of the first or second CFET rows of the DR CFET structure.

In some embodiments of a full-height cell, such as cell 200, a logic gate / logic function of the cell may be implemented by N ≥ 1 CFETs devices of each of the first and second CFET row of the DR CFET structure.

In some embodiments of a half-height cell or a full-height cell, a cell width of the cell may correspond to (N+1) times the CPP of the CFETs.

In some embodiments of a half-height cell or a full-height cell, the cell may comprise a respective pair of dummy gates, wherein the N CFETs (of the single row in case of a half-height cell, or of each row in case of a full-height cell) may be arranged between the respective pair of dummy gates. The signal pins (input or output pins) may hence be realized to be independent (i.e., separately accessible) from the signal pins of a neighboring cell abutting the third or fourth cell edge of the cell. The half-height cells 301, 302 in Fig. 5 and the full-height cell 200 are examples of such a configuration where N = 1 and their respective cell widths is 2 x CPP.

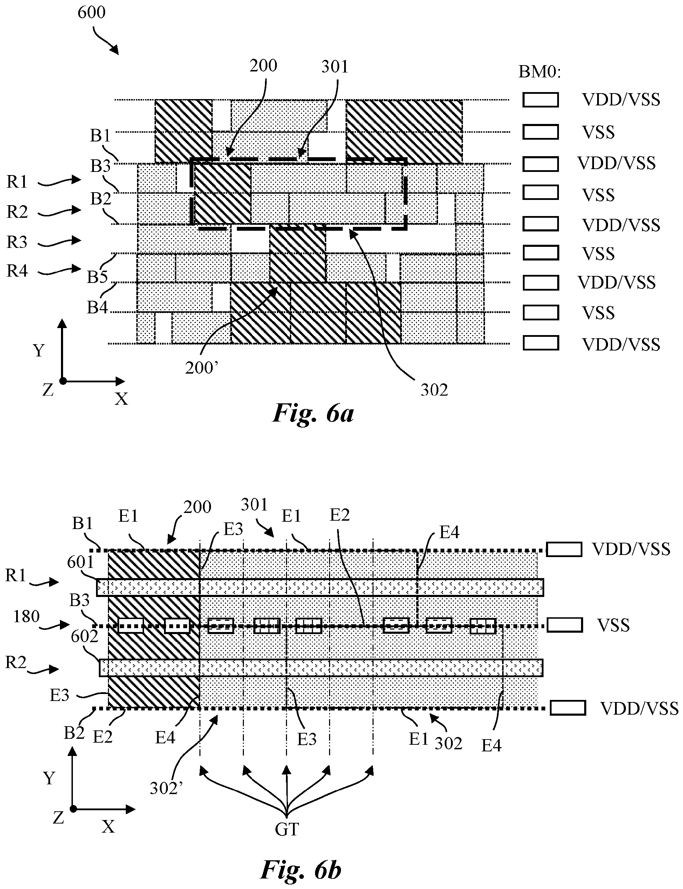

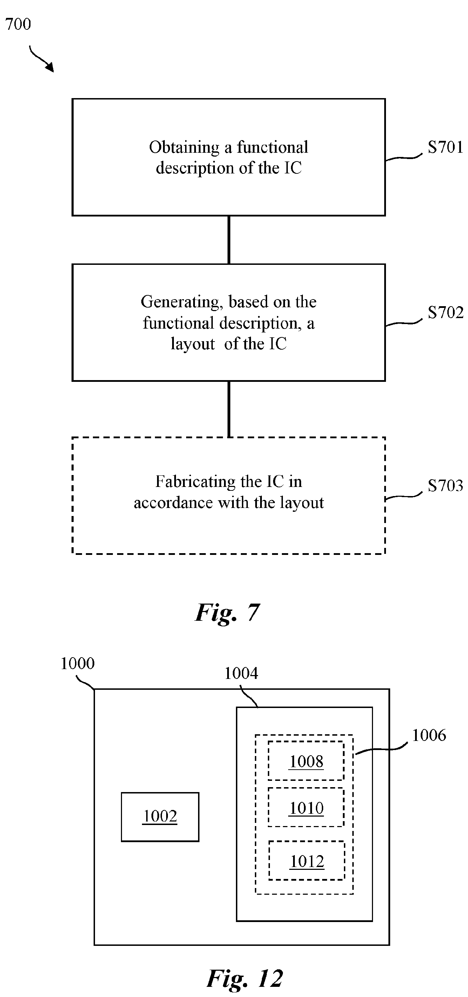

In the following, embodiments of a method for designing a layout of an IC using such a standard cell library comprising both full- and half-height standard cells will be disclosed with reference to Fig. 6a-b and Fig. 7. Fig. 7 is a flowchart of a method 700 for designing a layout of an IC based on the DR CFET architecture. Fig. 6a shows a top-down view of the resulting layout 600 (a physical layout) of the IC, generated by the method 700. Fig. 6b shows an enlargement of the encircled region of the layout 600 in Fig. 6a. In the layout 600, full-height cells are indicated with a diagonal striped pattern and half-height cells are indicated with a dotted pattern. To streamline the following discussion, reference will in the following mainly be made to a small subset of example full-height cells and half-height cells. These example cells will, like in Fig. 1-3, be denoted with reference signs 200, 301 and 302. The layout 600 may further, as indicated by the non-filled spaces in Fig. 6a, include areas not populated by any standard cells.

The method 700 begins at step S701 by obtaining a functional description of the IC. The functional description may comprise a functional description of the IC in the form of a gate-level netlist. A gate-level netlist may be generated from a hardware design language (HDL), for instance by translating a register transfer-level (RTL) definition to a gate-level netlist specific to the target technology node and the standard cell library.

At step S702, the method proceeds by generating the layout 600 based on the functional description obtained at step S701. Generating the layout 600 comprises placing standard cells in the layout 600, selected from the standard cell library in accordance with functional description. In accordance with the present disclosure, the selected cells may here include both full-height cells (such as cell 200) and half-height cells (such as cells 301, 302). Step S702 may be implemented as a PnR step in an Electronic Design Automation (EDA) flow. In particular, step S702 may be performed by an automatic place-and-route (APR) tool of an EDA system.

In accordance with standard cell methodology, the standard cells selected from the standard cell library are placed in a plurality of horizontally extending cell rows of the layout 600, such as cell rows R1-R4. The dotted horizontal lines (e.g., B1-B5) indicate boundaries between the cell rows. The cell rows have uniform (equal) heights in the vertical Y direction. Notably, the height of the half-height cells is equal to the height of the cell rows, while the height of the full-height cells is equal to two times the height of the cell rows. The width and placement of the standard cells may also be constrained in the horizontal X direction, e.g., in units of one or more CPPs of the transistor devices. Thus, the layout 600 defines a horizontal and vertical cell grid in which the standard cells may be placed.

The layout 600 further comprises, or defines, a power grid of power rail tracks. The power rail tracks are aligned with the row boundaries. In the layout 600, the global power rail tracks are provided as backside tracks BM0. In Fig. 6a, the locations of the backside tracks BM0 corresponding to BM0-1, BM0-3 and BM0-5 in Fig. 1-3 are schematically indicated at the right-hand side of the layout 600. The off-center BM0 tracks BM0-2 and BM0-4 are omitted for ease of illustration. As may be understood from the above, each backside track BM0 designated "VDD/VSS" indicates the location of bottom and top power rail tracks (corresponding to BM0-1 and PT1 or BM0-5 and PT2) for a stacked power rail structure corresponding to the power rail structures 150, 160 in Fig. 1-3. Each backside track BM0 designated "VSS" indicates the location of a global VSS (or VDD) power rail track (corresponding to BM0-3) for a global power rail corresponding to the power rail 170 in Fig. 1-3.

Now, placement of half-height cells will be discussed with reference to first and second (half-height) cells 301, 302 and a neighboring pair of first and second cell rows R1, R2. The first cell row R1 has a first row boundary B1, and the neighboring second cell row R2 has a second row boundary B2. The first and second cell rows R1, R2 further each have a shared third boundary B3 separating the first and second rows R1, R2.

With further reference to Fig. 6b, each of the first and second cells 301, 302 comprise respective first and second cell edges E1, E2 extending in parallel in the horizontal direction X, and respective third and fourth cell edges E3, E4 extending in parallel in the vertical direction Y and connecting the first and second cell edges E1, E2. The distance between the respective first and second cell edges E1, E2 define the cell height of the cells 301, 302. The distance between the respective third and fourth cell edges E3, E4 define the cell width of the cells 301, 302.

Each cell 301, 302 further comprises at least one CFET device. For ease of illustration, the CFET(s) of each cells 301, 302 are not individually shown, but instead represented by a respective active pattern 601, 602 disposed between the respective cell edges E1, E2 and extending in the horizontal direction X. Each cell 301, 302 comprises a single respective active pattern, wherein the CFET(s) of the cell 301, 302 (and its S/Ds and channel structures) are defined along the respective active pattern 601 and 602. The active patterns 601, 602 may as shown in Fig. 6b be disposed substantially midway between the cell edges E1, E2 of its associated cell 301, 302. More specifically, a centerline of the active pattern 601, 602 may be aligned with a centerline of the respective cell 301, 302.

Each of the CFETs may have a configuration corresponding to the CFETs 110, 112 of Fig. 3. For instance, each CFET of the first cell 301 may correspond to the CFET 110 and each CFET of the second cell 302 may correspond to the CFET 112. The number of CFETs of each cell 301, 302 will depend on the logic function implemented by the cell 301, 302. For instance, a more basic logic cell (e.g., a NOT) may be implemented using fewer CFETs than a more complex logic cell (e.g., a NAND).

Each cell 301, 302 further comprises at least one local interconnect (LI) 180. In Fig. 6b, LIs associated with half-height cells of the first cell row R1 (e.g., the first cell 301) and the second cell row R2 (e.g., the second cell 302) are respectively indicated by a horizontally striped fill pattern and a vertically striped fill pattern. That a LI 180 is "associated with" a given cell 301, 302 here means that the LI 180 is configured to connect to a bottom and/or top S/D (e.g., bottom and top S/D 124, 134 in Fig. 3) of at least one CFET device of the cell 301, 302. The LIs 180 of the first and second cells 301, 302 (two LIs of each cell in the present example) are disposed on the second cell edge E2 of the respective cells 301, 302. The number of LIs 180 of each cell 301, 302 will depend on the logic function implemented by the cell 301, 302. Hence, as may be seen in Fig. 6b, different half-height cells may include different numbers of LIs. For instance, the further half-height cell 302' in Fig. 6b includes a single LI 180.

Fig. 6b further indicates the locations of a number of gate tracks GT (dash-dot-dot line). The spacing of the gate tracks GT is given by the CPP of the CFETs. As shown, each LI 180 may be disposed between a respective pair of consecutive gate tracks GT.

As shown in Fig. 6b, the first and second cells 301, 302 are placed in the first and second cell rows R1, R2, respectively, such that:
- the first cell edge E1 of the first cell 301 aligns with the first row boundary B 1,
- the first cell edge E1 of the second cell 302 aligns with the second row boundary B2, and
- the second cell edges E2 of the first and second cells 301, 302 align with and abut each other along the third row boundary B3.

By this abutting placement, the individual LIs of the first and second cells 301, 302 align to form a common (shared) row of LIs 180 on the third row boundary B3.

Further, by placing the first and second cells 301, 302 in this manner, their respective power rail tracks (e.g., the BM0-1 and BM0-5 tracks, respectively) align with the global power rail tracks VDD/VSS of the layout 600.

As the row of LIs 180 is shared between the cells 301, 302 (i.e., the row of LIs 180 straddles the third row boundary B3 / the abutting second cell edges E2) the placement step S702 further comprises constraining the placement of the cells 301, 302 in the X direction to avoid placement conflicts between the LIs 180, i.e., such that the LIs 180 do not overlap.

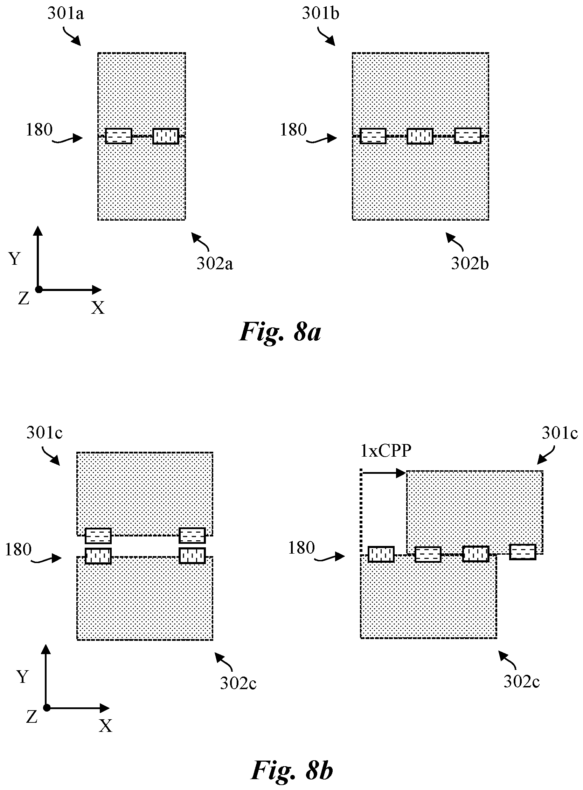

Fig. 8a schematically shows at the left-hand side a first example scenario of two half-height cells 301a and 302a. Each cell 301a, 302a has one respective LI. The respective layouts of the cells 301a and 302a are such that they may be placed side-by-side with abutting cell edges without causing any placement conflict in the row of LIs 180. Fig. 8a further shows at the right-hand side a second example scenario without placement conflicts, wherein the first and second cells 301b and 302b have two and one associated LI, respectively.

Fig. 8b schematically shows at the left-hand side a third example scenario of two half-height cells 301c and 302c. Here, each cell 301c, 302c has two respective LIs. However, in contrast to the first and second examples, the respective layouts of the cells 301c and 302c are such that they may not be placed with abutting cell edges if placed directly opposite each other without causing a placement conflict in the row of LIs 180. However, the placement (e.g., the APR tool) may resolve the placement conflict by displacing the cells 301c, 302c relative each other in the X direction. In the illustrated example, a displacement of 1xCPP resolves the placement conflict.

While the examples of Fig. 8a-b depict placement scenarios with reference to half-height cells of equal cell width, the discussion applies correspondingly to placement of first and second cells with different cell widths, as well as to various degrees of alignment in the horizontal direction X. For instance, as may be seen from the various arrangements of half-cells in Fig. 6a-b, first and second half-cells may be placed in a neighboring pair of cell rows separated by a shared row boundary, such that their respective second edges abut along the shared row boundary, and such that none, one or both of their respective vertical cell edges (i.e., their respective third and fourth cell edges) align. The abutting first and second half-cells may have equal cell widths or different cell widths.

To facilitate the placement constraint discussed above, the standard cell library may comprise cell layout data associated with each of the first and second cells 301, 302. The cell layout data may indicate (define) an in-cell location of any LI(s) of the respective cell 301, 302. The cell layout data for the first cell 301 may thus comprise coordinates for the LI(s) of the first cell 301. The coordinates for the LI(s) may be given in a coordinate system local to the first cell 301. Correspondingly, the cell layout data for the second cell 302 may comprise coordinates for the LI(s) of the second cell 302 (e.g., in a coordinate system local to the second cell 302). For example, the coordinates of any LI may be given by a start coordinate and an end coordinate in the horizontal direction, i.e., X-coordinates defining start and end coordinates of the LI. The method 700 may thus, at step S702, obtain the respective cell layout data associated with each of the first and second cells 301, 302, and perform the placement while taking the indicated LI coordinates into account. For example, the placement may involve a placement constraint for the LIs of the cells 301, 302 in terms of a horizontal minimum-spacing or minimum-pitch design rule (i.e., a minimum spacing or pitch in the X direction). Thereby, an APR tool may place the first and second cells 301, 302 to abut along the third row boundary B3, while ensuring that the minimum-spacing of the resulting shared row of LIs 180 is complied with. For instance, the minimum-spacing or minimum-pitch may correspond to one or more integer numbers of a CPP. This may facilitate finding a proper alignment between the first and second cells 301, 302, as the minimum-spacing thus may be defined in the same units as the horizontal spacing (resolution) of the grid of the layout 600.

It is noted that the cell layout data of the first and second cells 301, 302 further may define locations of any further structures or elements of the respective cells 301, 302, such as active gates, dummy gates, S/D contacts, any M0 metal lines, input and output pins, etc. Notably, the cell layout data may in some embodiments indicate an in-cell location of any M0 metal lines along their respective second cell edges E2. In the 3.5T implementation of Fig. 3, this corresponds to any M0 metal lines in the M0-4 track, which is shared between the cells 301, 302. The cell layout data may analogous to the discussion of the cell layout data pertaining to the LIs 180 comprise coordinates for any metal line in the edge track, e.g., in a coordinate system local to the respective cell 301, 302. For example, the coordinates of any M0 metal line may be given by a start coordinate and an end coordinate in the horizontal direction, i.e., X-coordinates defining start and end coordinates of the metal line. The method 700 may thus at step S702 (e.g., performed by an APR tool) obtain the respective cell layout data associated with each of the first and second cells 301, 302, and perform the placement while taking the indicated edge track M0 metal line coordinates (e.g., in the M0-4 track) into account. For example, a horizontal minimum-spacing design rule for the M0 metal lines may be applied in a corresponding fashion along the edge track M0-4.

The method 700 may at step S702 further comprise placement of one or more full-height cells, as will be discussed in the following with reference to the full-height cell (third cell) 200.

The cell 200 comprises, like the half-height cells 301, 302, first and second cell edges E1, E2 extending in parallel in the horizontal direction X, and third and fourth cell edges E3, E4 extending in parallel in the vertical direction Y and connecting the first and second cell edges E1, E2. The distance between the first and second cell edges E1, E2 define the cell height of the cell 200. The height of the cell 200 is equal to two times the row height and thus spans the distance between the first and second row boundaries B1, B2. The distance between the respective third and fourth cell edges E3, E4 define the cell width of the cells 301, 302.

The cell 200 further comprises at least one first CFET comprising / defined along the first active pattern 601 (e.g., of a first CFET row) and at least one second CFET comprising / defined along the second active pattern 602 (e.g., of a second CFET row) extending in parallel in the horizontal direction X. The above discussion of the active patterns 601, 602 with reference to the half-height cells 301, 302 applies correspondingly to the first and active patterns of the full-height cell 200.

Each of the first and second CFETs of the cell 200 may have a configuration corresponding to the CFETs 110, 112 of Fig. 1 or 2. For instance, each first CFET of the cell 200 may correspond to the CFET 110 and each second CFET of the cell 200 may correspond to the CFET 112. The number of first and second CFETs of the cell 200 will depend on the logic function implemented by the cell 200.

The cell 200 further comprises / is associated with at least one local interconnect 180 disposed mid-way between its first and second cell edges E1, E2. In Fig. 6b, the LIs associated with the full-height cell 200 are indicated without any fill pattern. Each LI 180 of the cell 200 is configured to connect to a top and/or bottom S/D of a first and/or second CFET of the cell 200.

As shown in Fig. 6b, the full-height cell 200 is placed in the first and second cell rows R1, R2 such that:
- its first cell edge E1 aligns with the first row boundary B1,
- its second cell edge E2 aligns with the second row boundary B2, and
- its at least one local interconnect 180 aligns with the third row boundary B3.

By this placement, the LIs 180 of the full-height cell 200 and the half-height cells 301, 302 align to form a common (shared) row of LIs 180 on the third row boundary B3. Further, their respective M0-4 tracks (shown in Fig. 3) align with each other along the third row boundary B3. Further, by placing the cell 200 in this manner, its power rail tracks (e.g., the BM0-1 and BM0-5 tracks, respectively) align with the global power rail tracks VDD/VSS of the layout 600.

In Fig. 6b, the full-height cell 200 is discussed with reference to the first and second cell rows R1, R2. However, this is merely an example, and a full-height cell may more generally be placed in any other pair of cell rows located between a pair of consecutive global power rail tracks VDD/VSS, such as in third and fourth cell rows R3, R4, as shown for a further full-height cell 200' in Fig. 6a. Here, the third cell 200' is placed such that its first cell edge aligns with the row boundary B2, its second cell edge aligns with the row boundary B4, and each of its LIs align with the row boundary B5 between the third and fourth cell rows R3, R4.

Each of the half-height cells and full-height cells selected from the standard cell library may be placed in cell rows of the layout in a corresponding fashion to generate the layout 600 as shown in Fig. 6a-b. As may be readily seen in Fig. 6b, the active pattern (e.g., 601 or 602) of any half-height cell placed in any given cell row (e.g., R1 or R2) aligns with the corresponding active pattern of any further half-height or full-height cells in the given cell row. Thus, one CFET row of a DR CFET structure is defined along each cell row. By combining full-height and half-height cells in this manner, an area-efficient layout may be obtained.

By comparison, another approach for avoiding unutilized cell area in DR CFET standard cells would be to purposefully design (e.g., manually draw) multi-bit implementations of "basic" logic gates (e.g., NOT, AND, NOR etc.). Considering as an example a single-bit logic gate that may be implemented using only a single row of a DR CFET structure, it may in some instances be possible to implement a further (e.g., identical) logic gate side-by-side using the second row of the DR CFET structure, and thus provide two individual logic gates within a same DR CFET standard cell. However, given the large number of logic gates often provided in a typical standard cell library, such an approach would require significantly higher engineering resources (design time, software enhancement, etc.) compared to the method 700.

Fig. 12 shows a schematic block diagram of a system 1000 suitable for implementing the method 700 of Fig. 7. The system 1000 may be a computing device. The system 1000 may comprise a processing device 1002 configured to implement the method. The processing device 1002 may for instance comprise one or more processors, such as one or more CPUs and/or one or more GPUs. The steps of the method may be implemented using software instructions which may be stored in a computer readable storage medium or section 1004 (e.g. on a non-transitory computer readable storage medium, volatile or non-volatile) to be executed by the processing device. The storage medium 1004 may further store a standard cell library 1006 comprising a collection of full-height DR CFET cells 1008 and half-height DR CFET cells 1010 in accordance with the preceding discussion. Each full-height and half-height cell 1008, 1010 of the standard cell library 1006 may be associated with respective cell layout data defining the layout of the cell, e.g., the locations of each element of the respective. The cell layout data may as mentioned above in particular indicate coordinates of any LIs of each respective cell, as well as of any M0 lines. The standard cell library 1006 may further include placement or design rule data 1012 defining placement constraints for the cells 1010, such as the above-mentioned minimum-spacing or minimum-pitch design rules. The storage medium 1004 and/or the standard cell library may additionally include auxiliary data needed to generate an IC layout as set out herein. The method 700 may be comprised in a software for a computer-aided design flow, such as in an EDA software, e.g., as part of an APR tool. The system 1000 may for example be a personal computer (e.g. a laptop or desktop computer), wherein the system 1000 further may comprise or be connected to a monitor and one or more input peripherals (e.g., a keyboard, a mouse, or the like) such that a designer may display and interact with a user interface of the EDA tool. The system 1000 may also be implemented as a server, providing a client computing device access to the EDA tool over a communications network, e.g., as a cloud-based service.

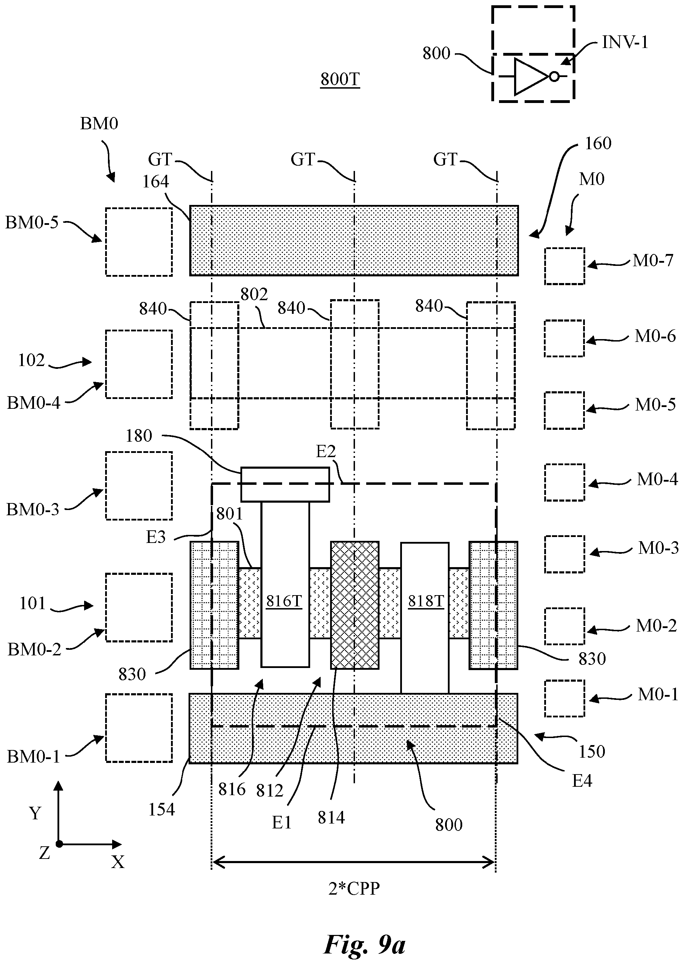

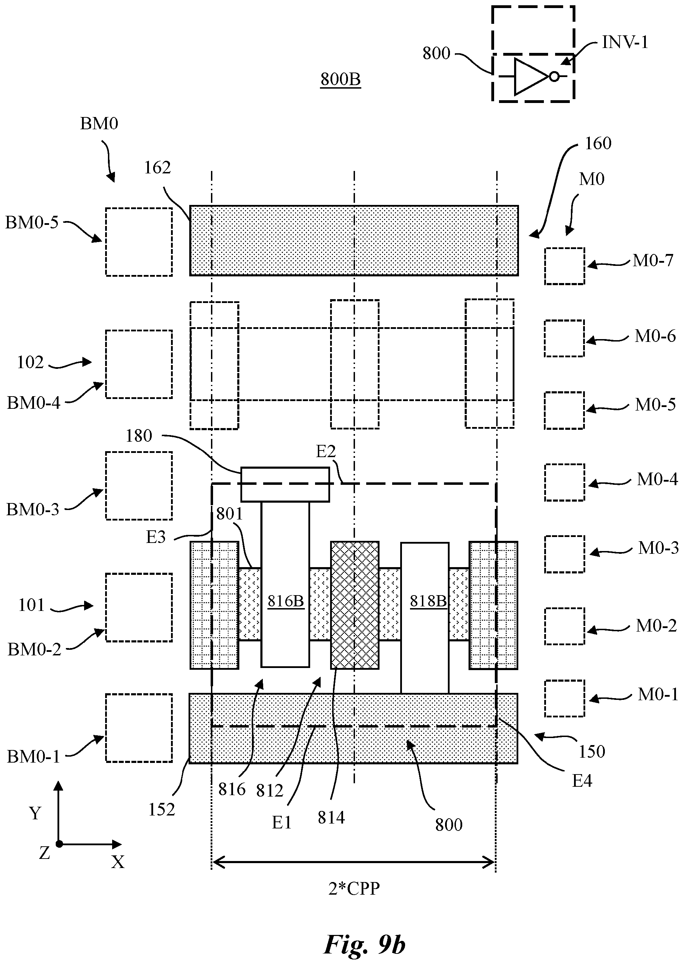

An example implementation of a half-height inverter cell 800 compatible with the method 700 of Fig. 7 will now be described with reference to Fig. 9a-b. Fig. 9a and 9b show example layouts of the top and bottom transistor tiers 800T, 800B, respectively, of the cell 800. Like reference signs will be used to refer to like elements, unless stated otherwise. For instance, consistent with Fig. 3, reference signs 101, 102 refer to first and second CFET rows; reference signs 150, 160 refer to first and second power rail structures; reference sign 180 refers to a LI or a row of LIs. Further consistent with Fig. 6a-b, reference signs E1-E2 and E3-E4 refer to horizontal and vertical cell edges of the cell 800, respectively. It is further noted that each of the CFETs referred to in the following may have a configuration corresponding to either of CFETs 110, 112 of Fig. 3. Also the labelling of backside BM0 and frontside M0 routing tracks is consistent with the preceding. To facilitate understanding, the cell 800 (although being a half-height cell) is shown in the context of a DR CFET structure, such that also the general location of features and elements associated with the second CFET row 102 may be seen, such as a second active pattern 802 and gates 840 (active or dummy).

The first cell edge E1 of the cell 800 is aligned with a centerline of the outer backside track BM0-1 track comprising the first stacked power rail structure 150. The second cell edge E2 is aligned with the centerline of the center backside track BM0-3.

The cell 800 comprises a CFET 812. The CFET 812 is comprised in a first CFET row 101, along a first active pattern 801. The CFET 812 is configured to implement an inverter (NOT) gate.

The CFET 812 comprises a gate 814 shared by its bottom and top transistor. The gate 814 is aligned with a gate track GT.

As may be seen in Fig. 9a, the top transistor of the CFET 812 is connected to the top power rail 154 by top S/D contact 818T. As may be seen in Fig. 9b, the bottom transistor of the CFET 812 is connected to the bottom power rail 152 by bottom S/D contact 818B. Thus, the CFET 812 is connected between the bottom and top power rails 152, 154, such that the power rail structure 150 is configured to power the cell 800.

The cell 800 further comprises a LI 180. The LI 180 is configured to interconnect a top and bottom S/D contact portion 816T, 816B of the CFET 812. The combination of the LI 180 and the top and bottom S/D contact portions 816T, 816B form a S/D contact structure 816.

The gate 814 is configured as an input node of the NOT cell/gate and is accordingly connected to an input pin of the logic cell 800. The S/D contact structure 816 is configured as an output node of the NOT cell /gate and is accordingly connected to an output pin of the cell 800. By the terms input and output "pin" of a logic cell is here meant a metal line or metal line segment connected to logic gate input / output nodes, respectively, to supply input signals to the cell 800 and provide output signals from the cell 800. The input and output pins may typically be arranged in M0 tracks of the M0 frontside interconnect layer. For example, the input pin may be arranged in the M0-2 track and the output pin may be arranged in the M0-3 track. The input pin may be connected to the gate 814 by a via, e.g., like the via 142 in Fig. 2. The output pin may be connected to the S/D contact structures 816 by a via, e.g., like the via 138 in Fig. 1.

The cell 800 further comprises a pair of dummy gates 830 aligned with respective gate tracks GT and disposed with their centerlines on the third and fourth cell edges E3, E4. Thus, the width of the cell 800 is 2*CPP, where CPP is the contacted poly pitch of the CFET 812 of the cell 800.

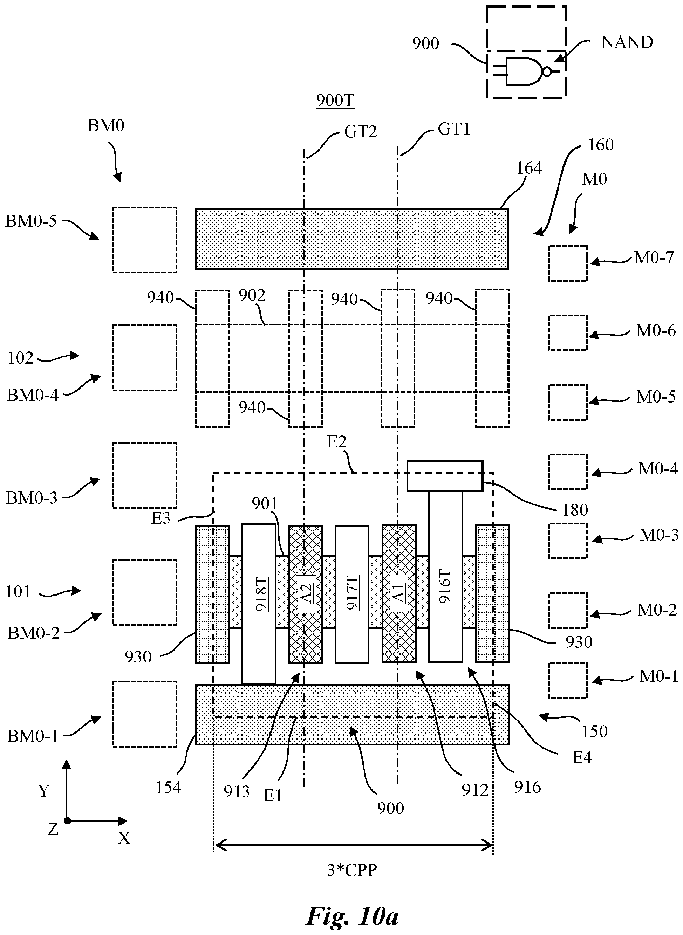

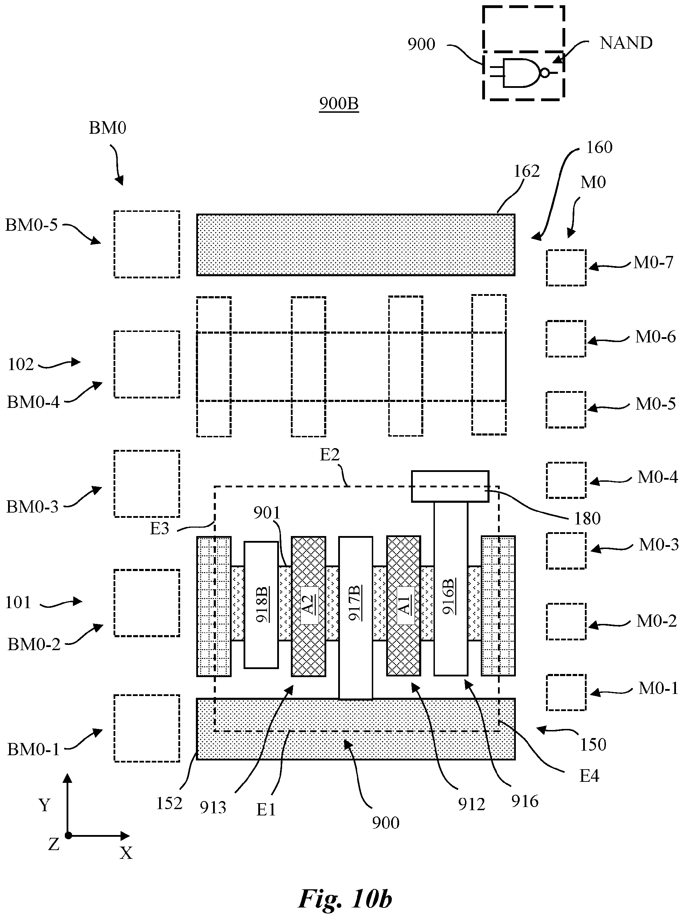

The cell 800 of Fig. 9a-b is implemented by one (N = 1) CFET of a respective CFET row. Fig. 10a-c shows a further example implementation of a half-height NAND cell 900 where N = 2. Fig. 10a and 10b show example layouts of the top and bottom transistor tiers 900T, 900B, respectively, of the cell 900. The cell 900 is like the cell 800 shown in the context of a DR CFET structure, such that also the general location of features and elements associated with the second CFET row 102 may be seen, such as a second active pattern 902 and gates 940 (active or dummy).

The logic cell 900 comprises a first and a second CFET 912, 913 disposed along a first active pattern 901. Each CFET 912, 913 comprises a respective gate A1, A2 shared by its bottom and top transistor. The gate A1 is aligned with a first gate track GT1. Correspondingly, the gate A2 is aligned with a second gate track GT2 parallel and consecutive to the first gate track GT1.

The logic cell 900 further comprises a LI 180. The LI 180 is configured to interconnect a top and bottom S/D contact portion 916T, 916B of the first CFET 912. The combination of the LI 180 and the top and bottom S/D contact portions 916T, 916B form a S/D contact structure 916.

The further connections of the CFETs 912, 913 to each other as well as to the respective power rail may be readily seen in Fig. 10a-b. Thus, the top and bottom S/D contacts 917T, 917B are shared by the CFETs 912 and 913. The respective bottom transistors of the CFETs 912 and 913 are connected to the bottom power rail 152 by the bottom S/D contact 917B. The top transistor of the CFET 913 is connected to the top power rail 154 by the top S/D contact 918T.

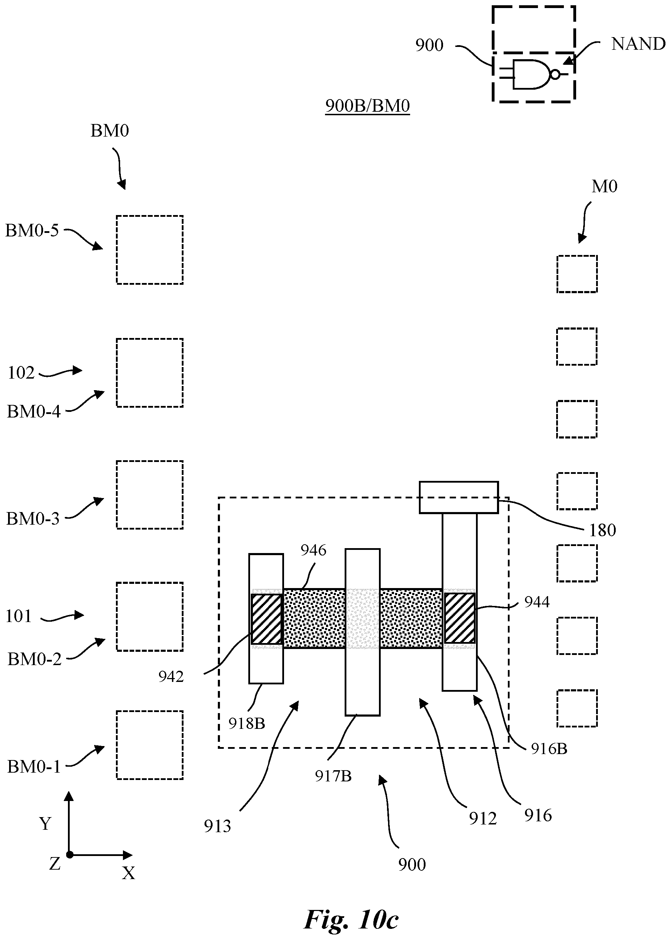

To complete the signal routing involved in a NAND gate, a connection is further needed between the bottom S/D contact 918B and the S/D contact structure 916. Fig. 10c is a further view of the bottom tier 900B of the logic cell 900, however omitting some elements to allow a simultaneous view of the backside interconnect layer BM0. As shown, to realize this connection, the cell 900 may utilize a metal line 946 disposed in a backside signal track BM0-2 underneath and aligned with the CFET row 101 and the active pattern 901. The metal line 946 is connected to the bottom S/D contacts 916B and 918B by a pair of backside contacts 942, 944 (e.g., analogous to the backside contact 129 of Fig. 2). The metal line 946 thus interconnects a pair of non-neighboring S/Ds of the CFETs 912, 913.

The gates A1, A2 of the CFETs 912, 913 are configured as input nodes of the NAND gate implemented by the cell 900, and accordingly connected to respective input pins of the logic cell 900. The S/D contact structure 916 is configured as an output node of the NAND gate, and accordingly connected to an output pin of the cell 900. For example, the two input pins may be arranged in the M0-2 track. The output pin may for example be arranged in the M0-3 track. The connections between the input / output pins and the gates and S/D contacts of the logic cell 900 may be realized by vias.

The CFETs 912, 913 are like in the inverter implementation of Fig. 9a-b surrounded by a pair of dummy gates 930, aligned with its third and fourth cell edges E3, E4. Thus, the logic cell 900 has a cell width (in the X direction) corresponding to (N+1)*CPP = 3*CPP.

In step S702 of the method 700 of Fig. 7, either one of the cell 800 or 900 may for example be placed such that its second cell edge E2 abuts a corresponding second cell edge of a further half-height cell (e.g., along the third row boundary B3). As may be appreciated from the above, the placement constraint on the LIs imposed by the method may be met provided the further cell lacks a LI between at least one pair of consecutive gate tracks GT.

A further merit of each of the layouts of the cells 800, 900 is that they may be placed side-by-side with a cell with an identical layout rotated by 180 degrees, in other words flipped and mirrored. Thereby, two independent inverter cells or NAND may be implemented side-by-side in two neighboring cell rows of a layout.

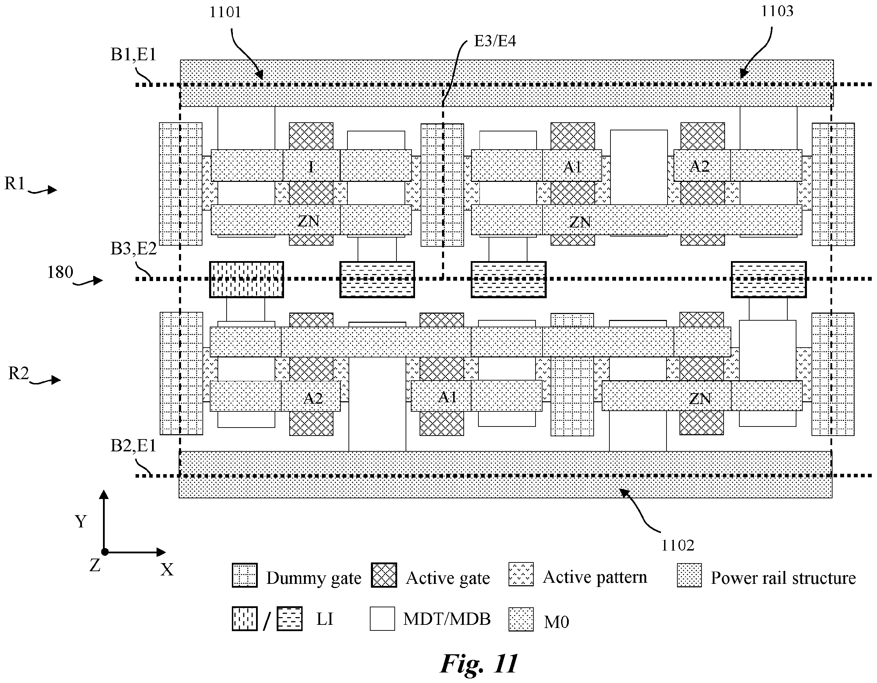

As may be seen already from Fig. 6a-b, the layout 600 may also comprise two or more half-height cells placed in a same cell row (e.g., R1) wherein each of the two cells abut a same half-height cell in a neighboring cell row (e.g., R2). Fig. 11 shows in greater detail one such example, showing an inverter cell 1101, an OR cell 1102 and a NAND cell 1103, each implemented as a respective half-height DR cell, and placed in an abutting configuration.

The inverter cell 1101 (representing a "first half-height cell"), the NAND cell 1103 (representing a "third half-height cell") and the OR cell 1102 (representing a "second half-height cell") are here placed in first and second cell rows R1, R2 such that:
- the first cell edge E1 of the inverter cell 1101 aligns with the first row boundary B1,
- the first cell edge E1 of the NAND cell 1103 aligns with the first row boundary B1,
- the first cell edge E1 of the OR cell 1102 aligns with the second row boundary B2, and
- the second cell edges E2 of each of the cells 1101, 1102, 1103 align with the third row boundary B3, wherein the second cell edges E2 of the inverter and NAND cells 1101, 1103 abut the second cell edge E2 of the OR cell 1102.

By this abutting placement, the individual LIs of the cells 1101, 1102, 1103 align to form a shared row of LIs 180 on the third row boundary B3.

The various elements of the cells 1101, 1102, 1103 may be derived from the layer legend at the bottom of the drawing area. The labels "I", "A1" and "A2" indicate possible placements of the input pins / nodes of the respective cells. The labels "ZN" indicate possible placements of the output pins / nodes of the respective cells. The inverter cell 1101 may be implemented in accordance with the inverter cell 800 of Fig. 9a-b. The NAND cell 1103 may be implemented in accordance with the NAND cell 900 of Fig. 10a-c. The OR cell 1102 may be implemented using the design principles set out in connection with the inverter and NAND cells 800, 900. For example, a LI 180 may be used to connect to bottom and/or top S/Ds of any one of its CFETs. The cell 1102 may be powered by the stacked power rail structure disposed along its first cell edge E1. An off-center backside signal track aligned with its CFETs (e.g., BM0-2 or BM0-4) may be used to interconnect a pair of non-neighboring S/Ds of its CFETs (e.g., as shown with respect to the NAND cell 900 in Fig. 10c).

The design method 700 set out in the above may be extended to encompass also fabrication of the IC represented by the layout 600. Thus, as shown in Fig. 7, step S702 of the method 700 may be followed by fabricating, at step S703, the IC in accordance with the layout.

According to an example fabrication process of an IC based on the DR CFET architecture, the CFET processing may be monolithic, wherein both top and bottom transistors are patterned together with a single active and dummy gate etch. The S/D regions may be formed by cutting the active between the dummy gates, blocking the top-device and growing a highly doped S/D region epitaxially for the bottom transistor. After depositing isolation layers covering the bottom S/D region, the S/D region for the top transistor may be grown. The dummy gate may then be removed, the nanosheets released, and the gate filled with the replacement metal to form the functional / active gates of the CFETs. In a next step top contact trenches (MDT) may be formed together with a "hanging" downward trench for the row of LIs. After completing the frontside back-end-of-line (FS-BEOL), and thus forming the frontside interconnect structure, the wafer may be bonded to a carrier wafer, flipped and the original wafer removed giving access again to the bottom transistors. Bottom contact trenches (MDB) for bottom S/D contacts may be formed. The process may then be finalized by formation of the backside interconnect structure.

The person skilled in the art realizes that the present invention by no means is limited to the examples described above. On the contrary, many modifications and variations are possible within the scope of the appended claims. For instance, the design principles of the inverter and NAND cells 800, 900 may be applied to realize other basic cells half-height DR CFET cells, such as AND-gates, OR-gates, NOR-gates, AND-OR-gates, AND-OR-INV-gates, OR-AND-gates, OR-AND-INV-gates.

Furthermore, while the above example embodiments involve placement of both half- and full-height cells, it is contemplated that an area-efficient layout, with the area- and manufacturability-related benefits associated with the DR CFET structure, may be generated from a standard cell library comprising only half-height cells. In other words, all cell rows of the layout may be allocated exclusively to half-height cells. While core logic in general may benefit from also more complex standard cells (such as those enabled by full-height cells), it is envisaged that this approach may be useful for simpler logic gates, at least for selected portions of an overall logic circuit.

## Claims

1. A computer-implemented method (700) for designing an integrated circuit comprising complementary field-effect transistor, CFET, devices, (110, 112) the method comprising:
obtaining (S701) a functional description of the integrated circuit; and
generating (S702), based on the functional description, a layout (600) of the integrated circuit, wherein the layout (600) defines first and second cell rows (R1, R2) extending in parallel in a horizontal direction (X) of the layout (600), and having equal row heights in a vertical direction (Y) of the layout (600), wherein the first cell row (R1) has a first row boundary (B1), the second cell row (R2) has a second row boundary (B2), and the first and second cell rows (R1, R2) are separated by a shared third row boundary (B3),
wherein generating the layout (600) comprises placing a first and a second cell (301, 302) of a standard cell library in the layout (600), each cell (301, 302) having a cell height equal to the row height, and comprising:
first and second cell edges (E1, E2) extending in parallel in the horizontal direction (X),
at least one CFET device (110, 112) having an active pattern (601, 602) extending in the horizontal direction (X), and
at least one local interconnect (180) disposed on the second cell edge (E2) and configured to connect to a top and/or bottom source/drain, S/D, (124, 134) of a CFET device (110) of the at least one CFET device of the cell,
wherein the first and second cells (301, 302) are placed in the first and second cell rows (R1, R2), respectively, such that:
the first cell edge (E1) of the first cell (301) aligns with the first row boundary (B1),
the first cell edge (E1) of the second cell (302) aligns with the second row boundary (B2), and
the second cell edges (E2) of the first and second cells (301, 302) align with and abut each other along the third row boundary (B3),
wherein the at least one local interconnect (180) of the first and second cells (301, 302) align to form a common row of local interconnects (180) on the third row boundary (B3), and
wherein the placement of the first and second cells (301, 302) is constrained such that the local interconnects (180) of the first and second cells (301, 302) do not overlap.

2. The method according to claim 1, wherein the first and second cells (301, 302) each further comprise: a bottom and top power rail track (BM0-1, PT1; BM0-5, PT2) associated with a bottom and top CFET device tier (100B, 100T), respectively, wherein the bottom and top power rail tracks are disposed on the first cell edge (E1) with the top power rail track overlapping the bottom power rail track.

3. The method according to any one of the preceding claims, wherein the local interconnects (180) of the first and second cells (301, 302) are vertically centered on the respective second cell edges (E2).

4. The method according to any one of the preceding claims, wherein the standard cell library further comprises cell layout data associated with the first and second cells (301, 302), the cell layout data indicating coordinates for the local interconnects (180) within the respective cells, wherein the placement of the first and second cells (301, 302) is based on the cell layout data.

5. The method according to claim 4, wherein the placement of the first and second cells (301, 302) is constrained such that the local interconnects (180) are separated by at least a predetermined minimum spacing in the horizontal direction (X).

6. The method according to any one of the preceding claims, wherein the first and second cells (301, 302) each comprise a set of signal routing tracks comprising an edge track (M0-4) disposed along the second cell edge (E2) of the respective cell (301, 302), wherein the placement of the first and second cells (301, 302) further is constrained such that any metal lines disposed in the edge tracks (M0-4) of the first and second cells (301, 302) do not overlap.

7. The method according to any one of the preceding claims, wherein generating the layout (600) further comprises placing a third cell (200, 200') of the standard cell library in the layout (600), the third cell (200, 200') having a cell height equal to two times the row height, and comprising:
first and second cell edges (E1, E2) extending in parallel in the horizontal direction (X),
at least one first CFET device (110) comprising a first active pattern (601) and at least one second CFET device (112) comprising a second active pattern (602), the first and second active patterns (601, 602) extending in parallel in the horizontal direction (X),
at least one local interconnect (180) disposed mid-way between the first and second cell edges (E1, E2) and configured to connect to a top and/or bottom S/D (124, 134) of a CFET device (110) of the at least one first CFET device, and/or of a CFET device (112) of the at least one second CFET device.

8. The method according to claim 7, wherein:
the third cell (200) is placed in the first and second cell rows (R1, R2) such that its first cell edge (E1) aligns with the first row boundary (B1), its second cell edge (E2) aligns with the second row boundary (B2), and its at least one local interconnect (180) aligns with the third row boundary (B3), and
the local interconnects (180) of the first, second and third cells (301, 302, 200) align to form a common row of interconnects (180) on the third row boundary (B3).

9. The method according to claim 8, wherein the first active pattern (601) of the third cell (200) aligns with the active pattern (601) of the first cell (301) and the second active pattern (602) of the third cell (200) aligns with the active pattern (602) of the second cell (302).

10. The method according to claim 7, wherein:
the layout (600) further defines third and fourth cell rows (R3, R4) parallel to the first and second cell rows (R1, R2) and having equal row heights to the first and second cell rows (R1, R2),
the third cell row (R3) has a fourth row boundary (B2), the fourth cell row (R4) has a fifth row boundary (B4), and the third and fourth cell rows (R3, R4) are separated by a shared sixth row boundary (B5), and
the third cell (200') is placed in the third and fourth cell rows (R3, R4) such that its first cell edge aligns with the fourth row boundary (B2) and its second cell edge aligns with the fifth row boundary (B4), and its at least one local interconnect aligns with the sixth row boundary (B5).

11. The method according to any one of claims 7-10, wherein the third cell (200) further comprises:
first bottom and top power rail tracks associated with a bottom and top device tier (100B, 100T), respectively, of the at least one first CFET device (110), and disposed on the first cell edge (E1) with the first top power rail track overlapping the first bottom power rail track, and
second bottom and top power rail tracks associated with a bottom and top device tier, respectively, of the at least one second CFET device (112), and disposed on the second cell edge (E2) with the second top power rail track overlapping the second bottom power rail track.

12. The method according to any one of the preceding claims, wherein the first and second cells (301, 302) each have a half-integer or integer track height of N, and when dependent on claim 7, the third cell (200) has a track height of 2 times N.

13. A method of fabricating an integrated circuit comprising:
designing the integrated circuit according to the method (700) of any one of claims 1-12, thereby obtaining a layout (600) of the integrated circuit; and
fabricating (S703) the integrated circuit in accordance with the layout.

14. A system (1000) for designing an integrated circuit comprising complementary field-effect transistors, CFETs, the system comprising:
a processing device (1002); and
a computer-readable storage medium (1004) storing instructions configured to, when executed by the processing device, cause the processing device (1002) to perform a method of any one of claims 1-12.

15. A computer program product comprising instructions configured to, when executed by a processing device, cause the processing device to perform a method of any one of claims 1-12.
